(19) Europäisches Patentamt
European Patent Office
Office européen des brevets

(11) **EP 4 703 811 A1**

(12) **EUROPEAN PATENT APPLICATION**
published in accordance with Art. 153(4) EPC

(43) Date of publication:
**04.03.2026  Bulletin 2026/10**

(21) Application number: **24796940.5**

(22) Date of filing: **19.04.2024**

(51) International Patent Classification (IPC):
***G05B 11/36*** *(2006.01)*

(52) Cooperative Patent Classification (CPC):
**G05B 11/36**

(86) International application number:
**PCT/JP2024/015610**

(87) International publication number:
**WO 2024/225193 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.04.2023  JP 2023072675**

(71) Applicant: **Panasonic Intellectual Property Management Co., Ltd.**
**Kadoma-shi, Osaka 571-0057 (JP)**

(72) Inventors:
• **SHIRAKI, Yuta**
  **Osaka 571-0057 (JP)**
• **FUJIWARA, Hiroshi**
  **Osaka 571-0057 (JP)**
• **ITO, Gimpei**
  **Osaka 571-0057 (JP)**

(74) Representative: **SSM Sandmair**
**Patentanwälte Rechtsanwalt**
**Partnerschaft mbB**
**Joseph-Wild-Straße 20**
**81829 München (DE)**

(54) **FREQUENCY CHARACTERISTIC MEASUREMENT METHOD AND FREQUENCY CHARACTERISTIC MEASUREMENT DEVICE**

(57)     A frequency response measurement method includes: outputting, to a servo system (20), a first excitation signal in a first frequency range; calculating a first frequency response of the servo system (20) in the first frequency range based on a first identification input signal and a first identification output signal obtained in a first sampling cycle from the servo system (20) to which the first excitation signal is inputted; outputting, to the servo system (20), a second excitation signal in a second frequency range forming a part of the first frequency range and generated based on the first frequency response; and calculating a second frequency response of the servo system (20) in the second frequency range based on a second identification input signal and a second identification output signal obtained in a second sampling cycle longer than or equal to the first sampling cycle from the servo system (20) to which the second excitation signal is inputted.

FIG. 7

First frequency response measurement processing Start

↓ S10
Output first excitation signal in first frequency range

↓ S20
Calculate first frequency response, based on first identification input signal and first identification output signal obtained in first sampling cycle

↓ S30
Output second excitation signal in second frequency range, based on first frequency response

↓ S40
Calculate second frequency response, based on second identification input signal and second identification output signal obtained in second sampling cycle

↓ S50
Output first frequency response, second frequency response, or both first frequency response and second frequency response

↓
End

**Description**

[Technical Field]

The present disclosure relates to a frequency response measurement method of measuring the frequency response of a servo system.

[Background Art]

There is known a technique for measuring the frequency response of a servo system (see, for example, Patent Literature (PTL) 1).

[Citation List]

[Patent Literature]

[PTL 1] Japanese Unexamined Patent Application Publication No. 2019-91141

[Summary of Invention]

[Technical Problem]

Highly accurate measurement of the frequency response of a servo system is awaited.
In view of this, the present disclosure aims to provide a frequency response measurement method and so forth capable of obtaining a highly accurate frequency response of a servo system.

[Solution to Problem]

A frequency response measurement method according to an aspect of the present disclosure is a frequency response measurement method of measuring a frequency response of a servo system, the frequency response measurement method including: outputting, to the servo system, a first excitation signal in a first frequency range; calculating a first frequency response of the servo system in the first frequency range based on a first identification input signal and a first identification output signal that are obtained in a first sampling cycle from the servo system to which the first excitation signal is inputted, the first identification input signal being a signal inputted to the servo system to obtain the frequency response of the servo system, the first identification output signal being a signal outputted from the servo system to obtain the frequency response of the servo system; outputting, to the servo system, a second excitation signal in a second frequency range that forms a part of the first frequency range, the second excitation signal being a signal generated based on the first frequency response; and calculating a second frequency response of the servo system in the second frequency range based on a second identification input signal and a second identification output signal that are obtained in a second sampling cycle that is longer than or equal to the first sampling cycle from the servo system to which the second excitation signal is inputted, the second identification input signal being a signal inputted to the servo system to obtain the frequency response of the servo system, the second identification output signal being a signal outputted from the servo system to obtain the frequency response of the servo system.
A frequency response measurement device according to an aspect of the present disclosure is a frequency response measurement device that measures a frequency response of a servo system, the frequency response measurement device including: a first outputter that outputs, to the servo system, a first excitation signal in a first frequency range; a frequency response calculator that calculates a first frequency response of the servo system in the first frequency range based on a first identification input signal and a first identification output signal that are obtained in a first sampling cycle from the servo system to which the first excitation signal is inputted, the first identification input signal being a signal inputted to the servo system to obtain the frequency response of the servo system, the first identification output signal being a signal outputted from the servo system to obtain the frequency response of the servo system; and a second outputter that outputs, to the servo system, a second excitation signal in a second frequency range that forms a part of the first frequency range, the second excitation signal being a signal generated based on the first frequency response, wherein the frequency response calculator further calculates a second frequency response of the servo system in the second frequency range based on a second identification input signal and a second identification output signal that are obtained in a second sampling cycle that is longer than or equal to the first sampling cycle from the servo system to which the second excitation signal is inputted, the second identification input signal being a signal inputted to the servo system to obtain the frequency response of the servo system, the second identification output signal being a signal outputted from the servo system to obtain the frequency response of the servo system.

[Advantageous Effects of Invention]

With the frequency response measurement method and so forth according to an aspect of the present disclosure, it is possible to obtain a highly accurate frequency response of a servo system.

[Brief Description of Drawings]

[FIG. 1]

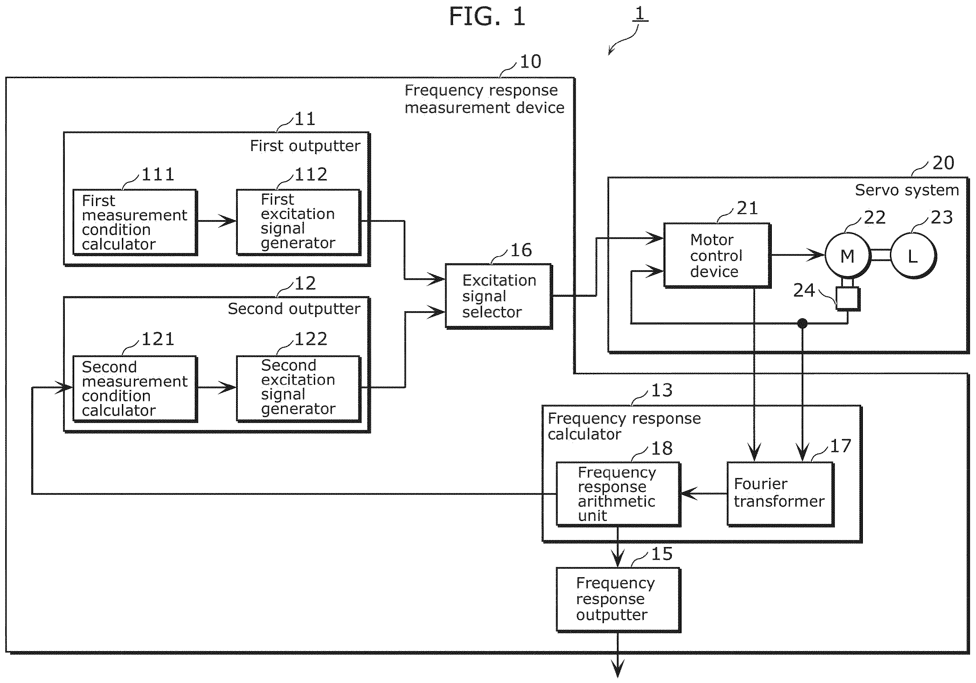

FIG. 1 is a block diagram showing the configuration of a frequency response measurement system according to Embodiment 1.

[FIG. 2A]

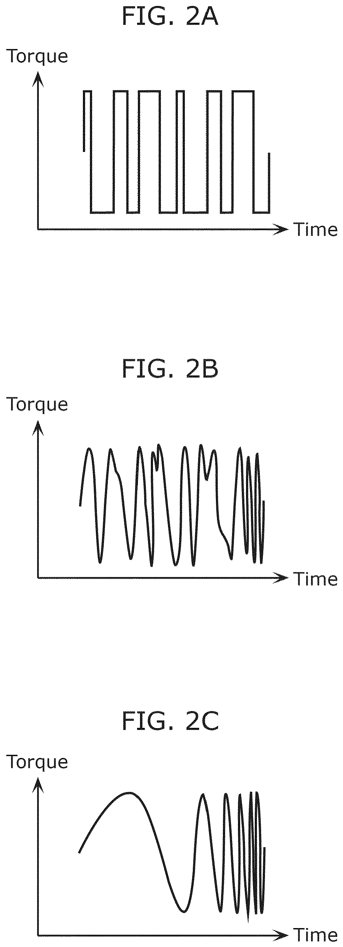

FIG. 2A is a waveform diagram showing an example of a white noise signal.

[FIG. 2B]
FIG. 2B is a waveform diagram showing an example of a multi-sine wave signal.

[FIG. 2C]
FIG. 2C is a waveform diagram showing an example of a sine wave sweep signal.

[FIG. 2D]

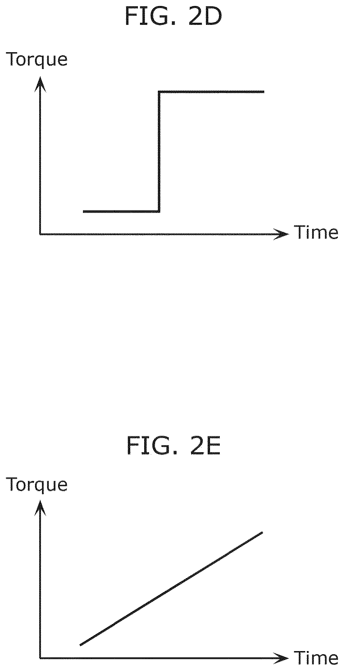

FIG. 2D is a waveform diagram showing an example of a step signal.

[FIG. 2E]
FIG. 2E is a waveform diagram showing an example of a ramp signal.

[FIG. 3]

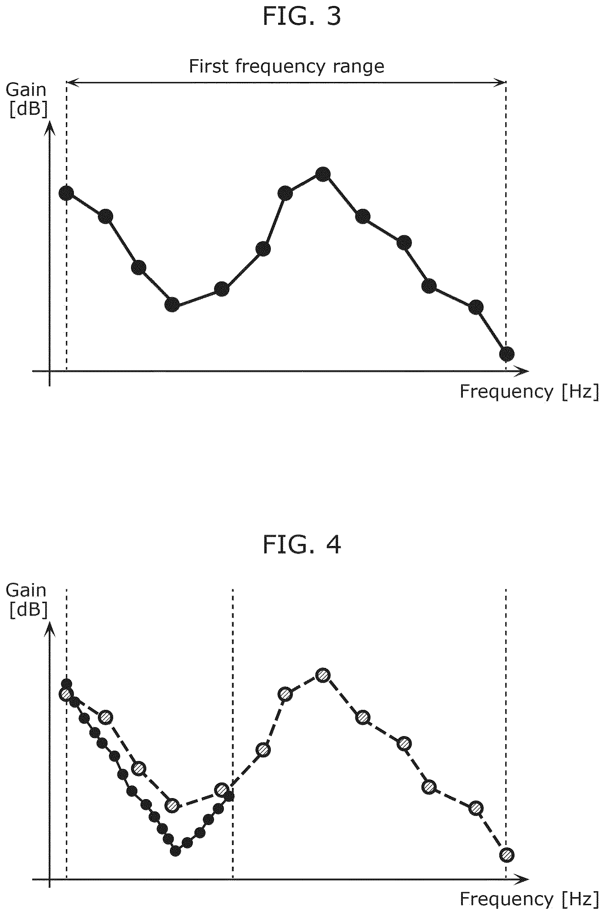

FIG. 3 is a Bode plot showing an example of a first frequency response calculated by a frequency response calculator according to Embodiment 1.

[FIG. 4]
FIG. 4 is a Bode plot showing an example of a frequency response calculated by the frequency response calculator according to Embodiment 1.

[FIG. 5]

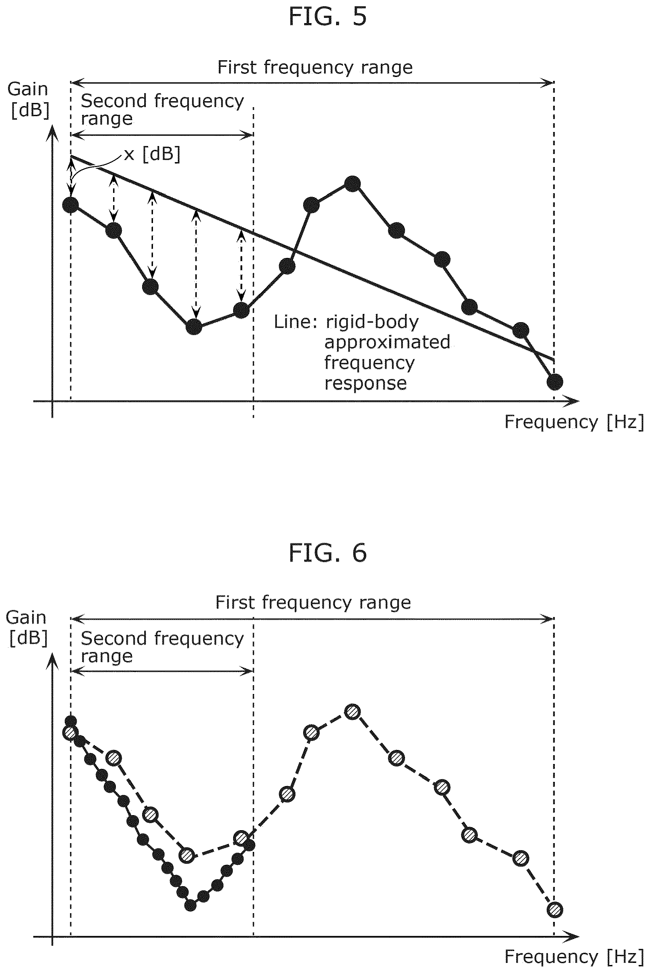

FIG. 5 is an example of a Bode plot in which the frequency response of a servo system approximated as a rigid body is overlaid on the first frequency response calculated by the frequency response calculator according to Embodiment 1.

[FIG. 6]
FIG. 6 is a Bode plot showing an example of a second frequency response calculated by the frequency response calculator according to Embodiment 1.

[FIG. 7]

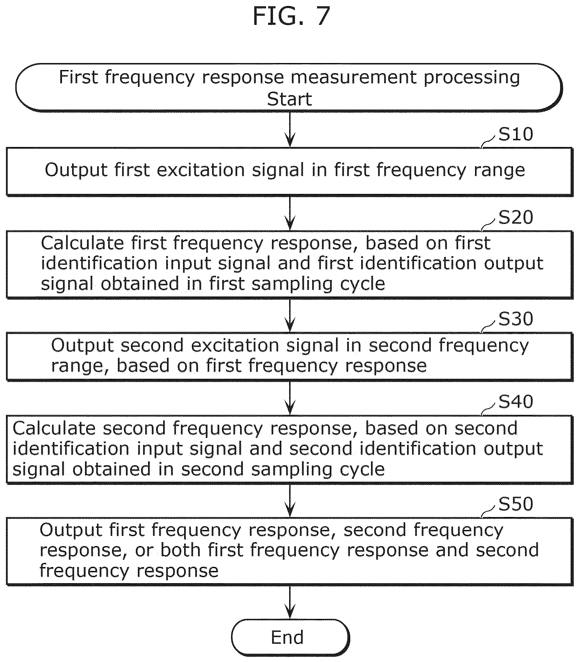

FIG. 7 is a flowchart of first frequency response measurement processing according to Embodiment 1.

[FIG. 8]

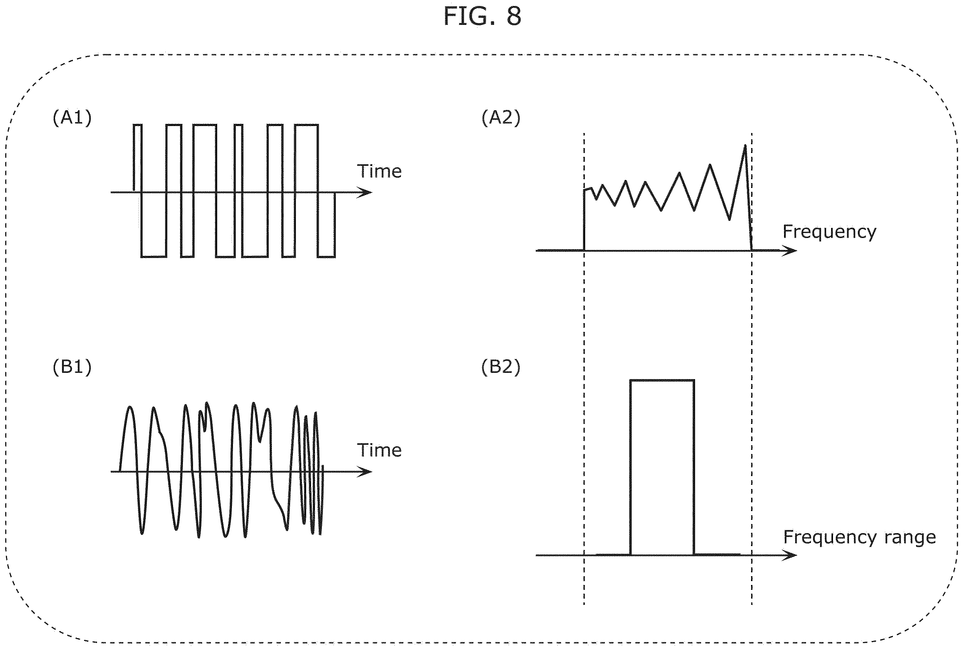

FIG. 8 is a diagram for describing the reason that the accuracy of the second frequency response becomes higher than the accuracy of the first frequency response if a second frequency range is narrower than a first frequency range.

[FIG. 9]

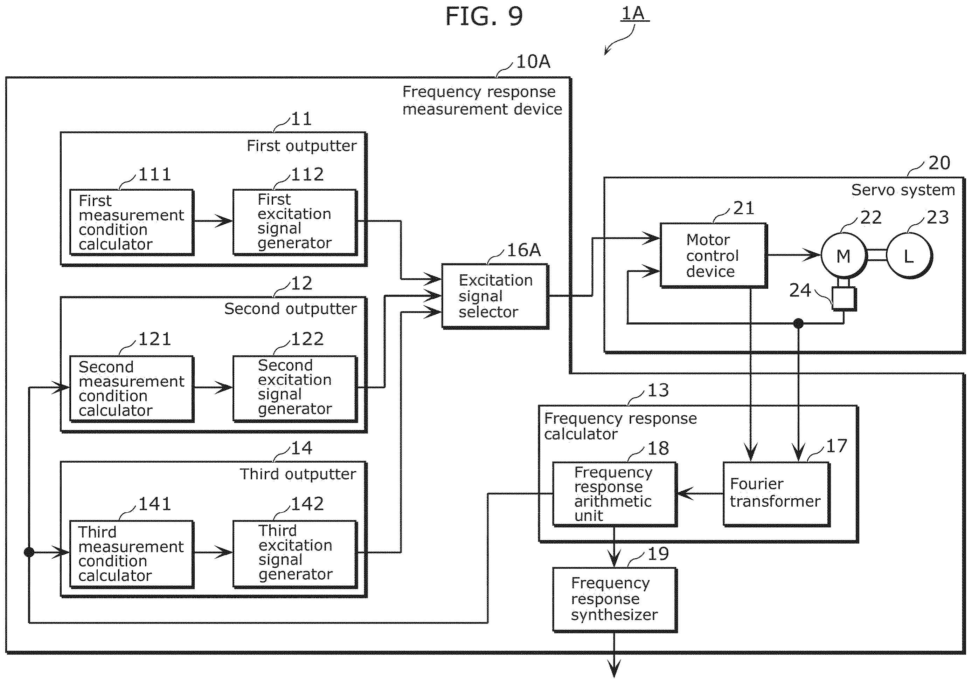

FIG. 9 is a block diagram showing the configuration of a frequency response measurement system according to Embodiment 2.

[FIG. 10]

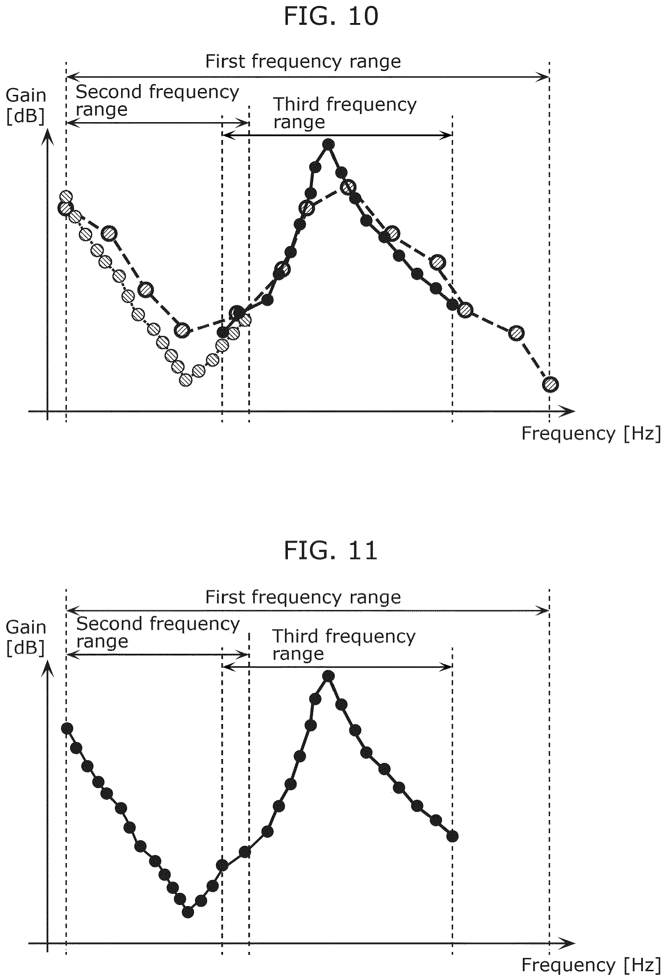

FIG. 10 is a Bode plot showing an example of a third frequency response calculated by the frequency response calculator according to Embodiment 2.

[FIG. 11]
FIG. 11 is a Bode plot showing an example of a fourth frequency response calculated by a frequency synthesizer according to Embodiment 2.

[FIG. 12]

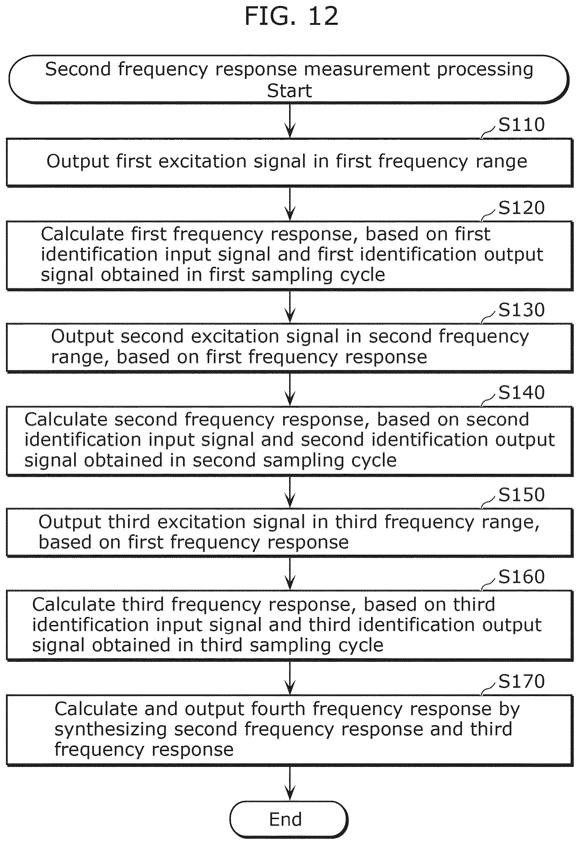

FIG. 12 is a flowchart of second frequency response measurement processing according to Embodiment 2.

[FIG. 13]

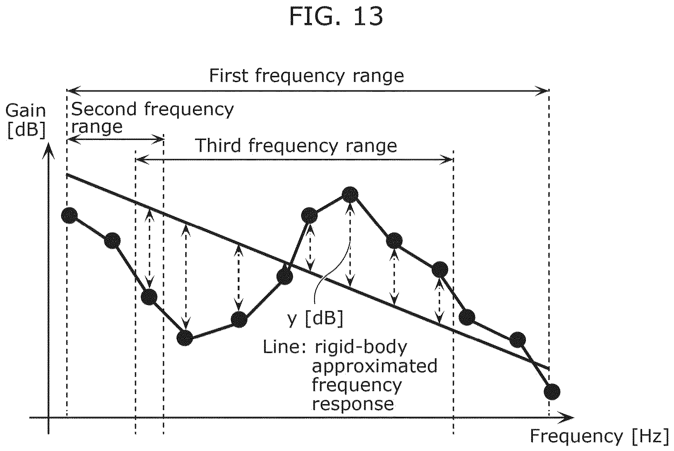

FIG. 13 is an example of a Bode plot in which the frequency response of the servo system approximated as a rigid body is overlaid on the first frequency response calculated by the frequency response calculator according to Embodiment 2.

[FIG. 14]

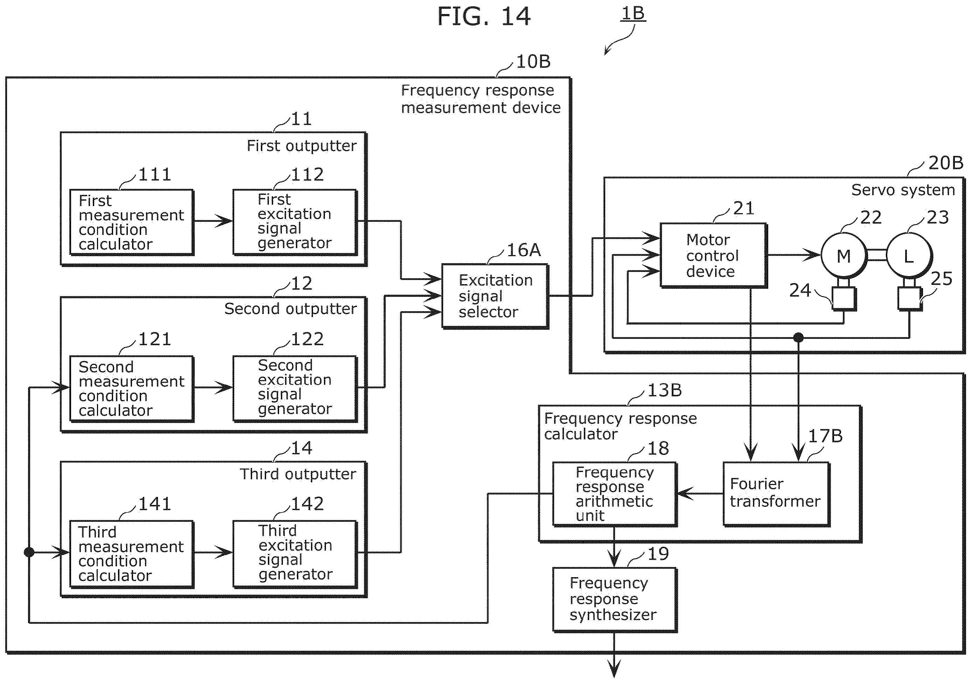

FIG. 14 is a block diagram showing the configuration of a frequency response measurement system according to Variation 1.

[FIG. 15]

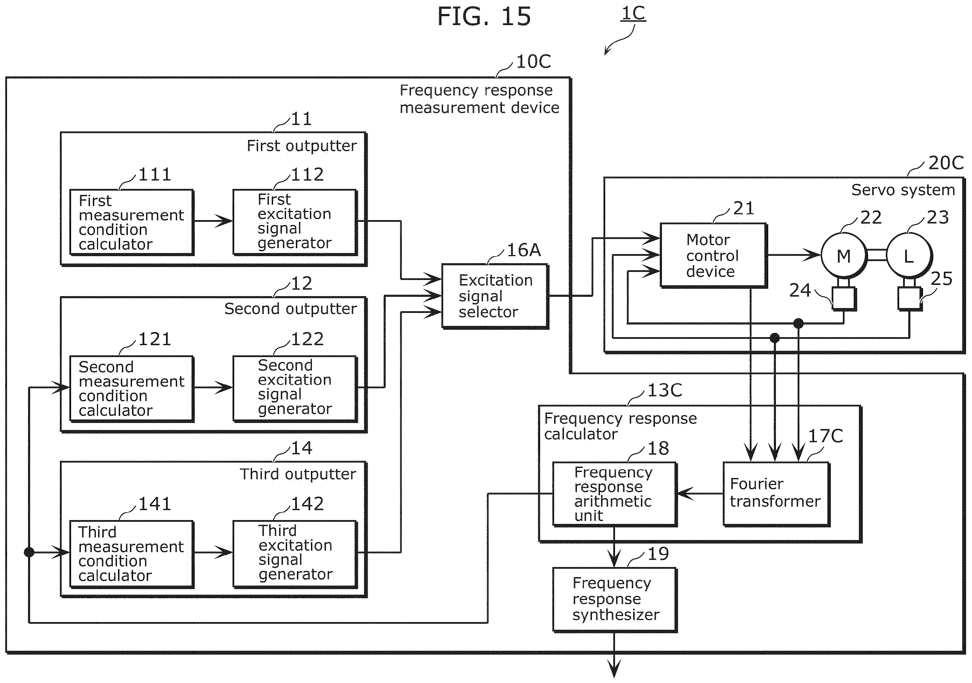

FIG. 15 is a block diagram showing the configuration of a frequency response measurement system according to Variation 2.

[FIG. 16]

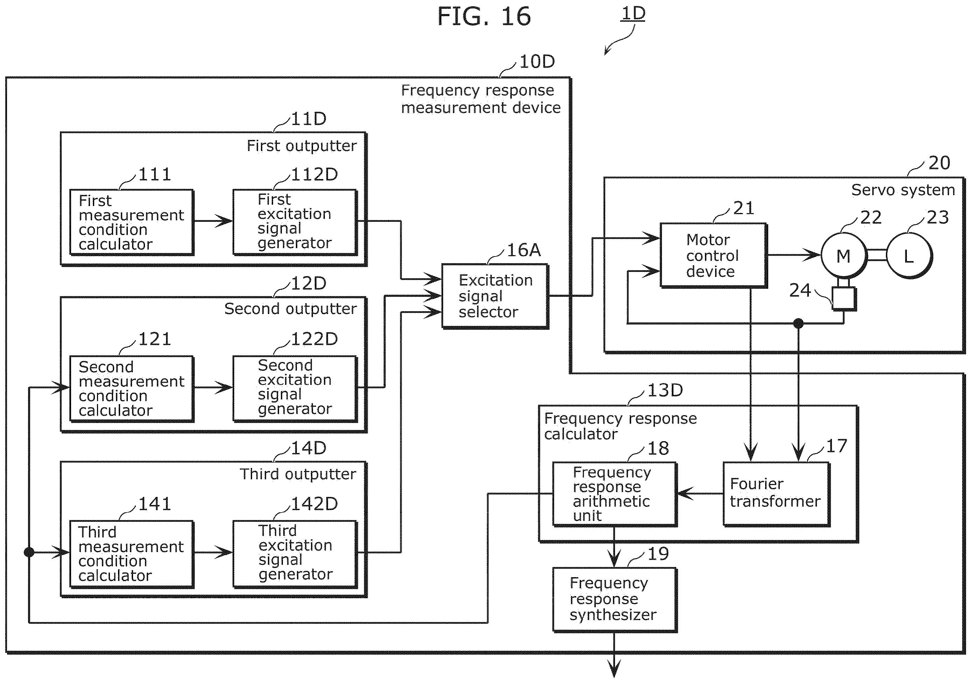

FIG. 16 is a block diagram showing the configuration of a frequency response measurement system according to Variation 3.

[Description of Embodiments]

(Circumstances Leading to an Aspect of the Present Disclosure)

When measuring the frequency response of a servo system by inputting, to such servo system, an excitation signal that includes frequency components in a frequency band that is subjected to frequency response measurement, it is necessary to set in advance conditions such as sampling cycle, frequency resolution, and frequency range.

When these conditions are not appropriately set, it may not be possible to correctly measure the resonance frequency or/and the anti-resonance frequency, or to have a grasp of the frequency responses in these frequency bands with high resolution.

When measuring the frequency response, it is also necessary to set in advance the amplitude of an excitation signal.

When the amplitude of an excitation signal is relatively small in a servo system with a relatively large inertia or a relatively large friction, the signal intensity of the excitation signal can be insufficient. This can result in the failure of accurately measuring the frequency response.

In a servo system with anti-resonance, the signal intensity of an excitation signal can be insufficient as a result of the attenuation of the excitation signal in the anti-resonance frequency band in which the gain is relatively low. This can result in the failure of accurately measuring the frequency response.

In contrast, when the amplitude of an excitation signal is set to be relatively large to accurately measure the frequency response in a servo system with resonance, devices that constitute the servo system can be damaged as a result of the amplification of the excitation signal in the resonance frequency band in which the gain is relatively high.

In particular, when using an excitation signal that includes all frequency components, such as a pseudo-random signal, or an excitation signal that allows the specification of the frequency range to be measured, such as a sine wave sweep signal, it is highly possible that devices that constitute the servo system are damaged because the signal intensity of the frequency components in the resonance frequency band becomes higher in the case of measuring the frequency response in a specified frequency range using the excitation signal that includes only the frequency components of the specified frequency range where the frequency range to be measured is limited than in the case of measuring the frequency response in a wide frequency range at one time using the excitation signal for which a wide range is set as a frequency range to be measured.

As described above, to obtain a highly accurate frequency response, it is necessary to set the amplitude of an excitation signal relatively large in measuring the frequency response. However, when the amplitude of the excitation signal is set to be relatively large, the risk increases of causing damage to the devices that constitute the servo system.

To obtain a highly accurate frequency response, therefore, it is necessary to set the amplitude of the excitation signal to be as large as possible within the range in which the devices that constitute the servo system will not be damaged. However, it is not easy to set such an amplitude.

In view of this, the inventors have conducted intensive studies and experiments on a frequency response measurement method capable of obtaining a highly accurate frequency response of a servo system that is subjected to frequency response measurement, even when such servo system is a system with a relatively large inertia or a relatively large friction, or with resonance or anti-resonance.

As a result, the inventors have obtained the following findings: first, the amplitude of an excitation signal is automatically calculated on the basis of the total inertia or the friction response of a servo system, and the excitation signal that includes frequency components of the entire frequency band subjected to frequency response measurement is inputted the servo system to measure the frequency response of the servo system, thereby grasping an overall perspective of the frequency response of the servo system; and then, on the basis of the overall perspective of the frequency response of the servo system that has been grasped, an excitation signal that includes a larger number of frequency components in a part of the entire frequency band subjected to the measurement is newly inputted to the servo system in a sampling cycle that is longer than or equal to the sampling cycle used for the first measurement to measure the frequency response of such servo system. It has been found that it is possible to obtain a highly accurate frequency response of the servo system on the basis of the frequency response measured first and the frequency response measured next, even when such servo system subjected to frequency response measurement is a system with a relatively large inertia or a relatively larger friction, or with resonance or anti-resonance.

The inventors have repeatedly conducted further studies and experiments on the basis of the foregoing findings to arrive at the frequency response measurement device to be disclosed below.

The frequency response measurement method according to an aspect of the present disclosure is a frequency response measurement method of measuring a frequency response of a servo system, the frequency response measurement method including: outputting, to the servo system, a first excitation signal in a first frequency range; calculating a first frequency response of the servo system in the first frequency range based on a first identification input signal and a first identification output signal that are obtained in a first sampling cycle from the servo system to which the first excitation signal is inputted, the first identification input signal being a signal inputted to the servo system to obtain the frequency response of the servo system, the first identification output signal being a signal outputted from the servo system to obtain the frequency response of the servo system; outputting, to the servo system, a second excitation signal in a second frequency range that forms a part of the first frequency range, the second excitation signal being a signal generated based on the first frequency response; and calculating a second frequency response of the servo system in the second frequency range based on a second identification input signal and a second identification output signal that are obtained in a second sampling cycle that is longer than or equal to the first sampling cycle from the servo system to which the second excitation signal is inputted, the second identification input signal being a signal inputted to the servo system to obtain the frequency response of the servo system, the second identification output signal being a signal outputted from the servo system to obtain the frequency response of the servo system.

According to the above frequency response measurement method, the second frequency range of the second excitation signal is narrower than the first frequency range of the first excitation signal. For this reason, when the energy provided to the servo system by the first excitation signal and the second excitation signal is the same, the signal intensity of the second excitation signal becomes higher than the signal intensity of the first excitation signal in the second frequency range.

Thus, according to the above frequency response measurement method, it is possible to obtain the second frequency response that is further more accurate than the first frequency response in the second frequency range.

Further, according to the above frequency response measurement method, the second sampling cycle is longer than the first sampling cycle.

In general, the frequency resolution of the frequency response is a value obtained by dividing the sampling frequency, which is the inverse of the sampling cycle, by the number of measurement data points. For this reason, when the number of measurement data points is the same between when the first frequency response is calculated and when the second frequency response is calculated, the frequency resolution of the second frequency response is higher than or equal to the frequency resolution of the first frequency response.

Thus, according to the above frequency response measurement method, it is possible to obtain the second frequency response that is further more accurate than the first frequency response in the second frequency range.

As described above, according to the above frequency response measurement method, it is possible to obtain a highly accurate frequency response of the servo system.

Also, the second sampling cycle may be longer than the first sampling cycle.

Also, the first excitation signal may be any one of a pseudo random signal, a multi-sine wave signal, a sine wave sweep signal, a step signal, or a ramp signal.

Also, the second excitation signal may be any one of a multi-sine wave signal or a sine wave sweep signal.

By using, as the second excitation signal, a signal that allows the specification of a frequency range, it is possible to reliably make the second frequency range narrower than the first frequency range. With this, when the energy provided to the servo system by the first excitation signal and the second excitation signal is the same, it is possible to reliably make the signal intensity of the second excitation signal higher than the signal intensity of the first excitation signal in the second frequency range.

The frequency response measurement method may further include: calculating an amplitude of the first excitation signal based on at least one of a total inertia or a friction response of the servo system, wherein the outputting of the first excitation signal may include outputting, to the servo system, the first excitation signal having the amplitude of the first excitation signal calculated in the calculating of the amplitude of the first excitation signal.

With this, it is possible to output, to the servo system, the first excitation signal having a more appropriate amplitude that is set in accordance with at least one of the total inertia or the friction response of the servo system.

Thus, according to the above frequency response measurement method, in the first frequency range, it is possible to prevent a decrease in the accuracy of the frequency response caused by an insufficient signal intensity of the first excitation signal or/and to prevent the risk of damage to the devices that constitute the servo system caused by an excessively high signal intensity of the first excitation signal.

The frequency response measurement method may further include: calculating an amplitude of the second excitation signal based on the first frequency response, wherein the outputting of the second excitation signal may include outputting, to the servo system, the second excitation signal having the amplitude of the second excitation signal calculated in the calculating of the amplitude of the second excitation signal.

With this, it is possible to output, to the servo system, the second excitation signal having a more appropriate amplitude that is set in accordance with the first frequency response.

Thus, according to the above frequency response measurement method, it is possible to obtain a more accurate second frequency response in the second frequency range while reducing the risk of damage to the devices that constitute the servo system.

The frequency response measurement method may further include: outputting, to the servo system, a third excitation signal in a third frequency range, the third excitation signal being a signal generated based on the first frequency response, the third frequency range being a frequency range that forms a part of the first frequency range and defined by a first frequency that is higher than a lower limit frequency of the second frequency range and a second frequency that is higher than or equal to an upper limit frequency of the second frequency range; and calculating a third frequency response of the servo system in the third frequency range based on a third identification input signal and a third identification output signal that are obtained in a third sampling cycle that is longer than or equal to the first sampling cycle from the servo system to which the third excitation signal is inputted, the third identification input signal being a signal inputted to the servo system to obtain the frequency response of the servo system, the third identification output signal being a signal outputted from the servo system to obtain the frequency response of the servo system.

According to the above frequency response measurement method, the third frequency range of the third excitation signal is narrower than the first frequency range of the first excitation signal. For this reason, when the energy provided to the servo system is the same between the first excitation signal and the third excitation signal, the signal intensity of the third excitation signal is higher than the signal intensity of the first excitation signal in the third frequency range.

Thus, according to the above frequency response measurement method, it is possible to obtain the third frequency response that is further more accurate than the first frequency response in the third frequency range.

Further, according to the above frequency response measurement method, the third sampling cycle is longer than or equal to the first sampling cycle.

In general, the frequency resolution of the frequency response is a value obtained by dividing the sampling frequency, which is the inverse of the sampling cycle, by the number of measurement data points. For this reason, when the number of measurement data points is the same between when the first frequency response is calculated and when the third frequency response is calculated, the frequency resolution of the third frequency response is higher than or equal to the frequency resolution of the first frequency response.

Thus, according to the above frequency response measurement method, it is possible to obtain the third frequency response that is further more accurate than the first frequency response in the third frequency range.

The frequency response measurement method may further include: synthesizing the second frequency response and the third frequency response to calculate a fourth frequency response of the servo system.

With this, it is possible to obtain a further more accurate frequency response than the first frequency response in the fourth frequency range that is wider than the second frequency range and the third frequency range.

Also, the third sampling cycle may be longer than the first sampling cycle.

Also, the second frequency range and the third frequency range may be continuous.

With this, there exists no overlapping range in the second frequency range and the third frequency range. It is thus possible to obtain a further more accurate frequency response than the first frequency response in the wide fourth frequency range than in the case where the second frequency range and the third frequency range overlap.

Also, the lower limit frequency in the third frequency range may be within the second frequency range.

Also, at least one of the second frequency range or the third frequency range may include at least one of a resonance frequency or an anti-resonance frequency of the servo system.

With this, it is possible to obtain a further more accurate frequency response than the first frequency response in a frequency range that includes at least one of the resonance frequency or the anti-resonance frequency.

The frequency response measurement method may further include: outputting, to a display device, at least one of the second frequency response, the third frequency response, or the fourth frequency response.

With this, it is possible for a user using the above frequency response measurement method to have a grasp of at least one of the second frequency response, the third frequency response, or the fourth frequency response by viewing the display device.

The frequency response measurement method may further include: calculating an amplitude of the first excitation signal based on at least one of a total inertia or a friction response of the servo system, and control parameter setting of the servo system; and calculating an amplitude of the second excitation signal based on the first frequency response and the control parameter setting, wherein the outputting of the first excitation signal may include outputting, to the servo system, the first excitation signal having the amplitude of the first excitation signal calculated in the calculating of the amplitude of the first excitation signal, and the outputting of the second excitation signal includes outputting, to the servo system, the second excitation signal having the amplitude of the second excitation signal calculated in the calculating of the amplitude of the second excitation signal.

With this, it is possible to output, to the servo system, the first excitation signal having a more appropriate amplitude that is set in accordance with at least one of the total inertia or the friction response of the servo system, and the control parameters of the servo system.

Thus, according to the above frequency response measurement method, in the first frequency range, it is possible to prevent a decrease in the accuracy of the frequency response caused by an insufficient signal intensity of the first excitation signal or/and to prevent the risk of damage to the devices that constitute the servo system caused by an excessively high signal intensity of the first excitation signal.

It is further possible to output, to the servo system, the second excitation signal having a more appropriate amplitude that is set in accordance with the first frequency response and the control parameters of the servo system.

Thus, according to the above frequency response measurement method, it is further possible to obtain a more accurate second frequency response in the second frequency range while reducing the risk of damage to the devices that constitute the servo system.

Also, the first identification output signal and the second identification output signal may each include sensor information indicating a state quantity of a target to be driven in the servo system, the state quantity being obtained by sensing the target to be driven.

Also, the outputting of the first excitation signal may include outputting the first excitation signal a plurality of times, the outputting of the second excitation signal may include outputting the second excitation signal a plurality of times, the calculating of the first frequency response may include calculating the first frequency response based on each of the first identification input signal and the first identification output signal that are obtained a plurality of times from the servo system to which the first excitation signal is inputted a plurality of times, and the calculating of the second frequency response may include calculating the second frequency response based on each of the second identification input signal and the second identification output signal that are obtained a plurality of times from the servo system to which the second excitation signal is inputted a plurality of times.

With this, it is possible to obtain more accurate frequency response of the servo system.

Also, the first identification input signal and the second identification input signal may have an equal sampling number.

With this, it is possible to use, as a common storage region, a storage region for storing the first identification input signal and a storage region for storing the second identification signal. This eliminates the necessity of securing an additional storage region for storing the identification input signals.

The frequency response measurement device according to an aspect to the present disclosure is a frequency response measurement device that measures a frequency response of a servo system, the frequency response measurement device including: a first outputter that outputs, to the servo system, a first excitation signal in a first frequency range; a frequency response calculator that calculates a first frequency response of the servo system in the first frequency range based on a first identification input signal and a first identification output signal that are obtained in a first sampling cycle from the servo system to which the first excitation signal is inputted, the first identification input signal being a signal inputted to the servo system to obtain the frequency response of the servo system, the first identification output signal being a signal outputted from the servo system to obtain the frequency response of the servo system; and a second outputter that outputs, to the servo system, a second excitation signal in a second frequency range that forms a part of the first frequency range, the second excitation signal being a signal generated based on the first frequency response, wherein the frequency response calculator further calculates a second frequency response of the servo system in the second frequency range based on a second identification input signal and a second identification output signal that are obtained in a second sampling cycle that is longer than or equal to the first sampling cycle from the servo system to which the second excitation signal is inputted, the second identification input signal being a signal inputted to the servo system to obtain the frequency response of the servo system, the second identification output signal being a signal outputted from the servo system to obtain the frequency response of the servo system.

According to the above frequency response measurement method, the second frequency range of the second excitation signal is narrower than the first frequency range of the first excitation signal. For this reason, when the energy provided to the servo system by the first excitation signal and the second excitation signal is the same, the signal intensity of the second excitation signal is higher than the signal intensity of the first excitation signal in the second frequency range.

Thus, according to the above frequency response measurement device, it is possible to obtain the second frequency response that is further more accurate than the first frequency response in the second frequency range.

Further, according to the above frequency response measurement device, the second sampling cycle is longer than or equal to the first sampling cycle.

In general, the frequency resolution of the frequency response is a value obtained by dividing the sampling frequency, which is the inverse of the sampling cycle, by the number of measurement data points. For this reason, when the number of measurement data points is the same between when the first frequency response is calculated and when the second frequency response is calculated, the frequency resolution of the second frequency response is higher than or equal to the frequency resolution of the first frequency response.

Thus, according to the above frequency response measurement device, it is possible to obtain the second frequency response that is further more accurate than the first frequency response in the second frequency range.

As described above, according to the above frequency response measurement device, it is possible to obtain a highly accurate frequency response of the servo system.

Hereinafter, a specific example of the frequency response measurement system according to an aspect of the present disclosure is described with reference to the accompanying Drawings. Each of the exemplary embodiments described below shows a general or specific example. The numerical values, shapes, elements, the arrangement and connection of the elements, steps (processes), the processing order of the steps etc. shown in the following exemplary embodiments are mere examples, and therefore do not limit the scope of the present disclosure. The drawings are schematic diagrams, and thus they are not always exactly illustrated. Also, substantially the same elements are assigned the same reference marks throughout the drawings, and overlapping description may be omitted or simplified.

[Embodiment 1]

The following describes a frequency response measurement system according to Embodiment 1. Such frequency response measurement system is a system for measuring the frequency response of a servo system.

<Configuration>

FIG. 1 is a block diagram showing the configuration of frequency response measurement system 1 according to Embodiment 1.

As shown in FIG. 1, frequency response measurement system 1 includes frequency response measurement device 10 and servo system 20.

Servo system 20, which is a target subjected to frequency response measurement performed by frequency response measurement device 10, includes motor control device 21, motor 22, load 23, and first state quantity measurement device 24.

Motor 22 is controlled by motor control device 21 and drives load 23. The description here assumes that motor 22 is a rotary motor. Motor 22, however, is not necessarily limited to a rotary motor and may be, for example, a linear motor.

Load 23 is the target to be driven in servo system 20 and is driven by motor 22.

First state quantity measurement device 24 measures, from servo system 20, the state quantity of servo system 20 and outputs a state signal indicating the measured state quantity of servo system 20. The description here assumes that first state quantity measurement device 24 outputs, as the state signal, the state quantity related to motor 22. More specifically, the description here assumes that first state quantity measurement device 24 is an encoder that measures the rotational position of motor 22 and outputs a state signal indicating the rotational position of motor 22. First state quantity measurement device 24, however, is not necessarily limited to the above encoder, as long as first state quantity measurement device 24 is a device capable of measuring the state quantity of servo system 20 and outputting a state signal indicating the measured state quantity of servo system 20. First state quantity measurement device 24 may also be, for example, a sensor that measures the rotational speed of motor 22 and outputs a state signal indicating the rotational speed of motor 22.

Motor control device 21 performs control to cause a state quantity instruction inputted and the state quantity of the motor to coincide. In Embodiment 1, motor control device 21 controls motor 22 on the basis of excitation signals (a first excitation signal and a second excitation signal to be described later) outputted from frequency response measurement device 10. The description here assumes that each of the excitation signals outputted from frequency response measurement device 10 is a torque instruction (hereinafter also referred to as "input torque instruction") for specifying the torque of motor 22. The description here also assumes that, upon receiving an input of an input torque instruction outputted from frequency response measurement device 10, motor control device 21 outputs, to motor 22, a feedback torque instruction for causing the input torque instruction and the torque generated in the motor to coincide, utilizing a first state signal outputted from first state quantity measurement device 24. However, motor control device 21 is not necessarily limited to having the above configuration, as long as motor control device 21 is capable of controlling motor 22 on the basis of the excitation signals outputted from frequency response measurement device 10. For example, motor control device 21 may also be configured to directly output the excitation signals without performing feedback control for the excitation signals outputted from frequency response measurement device 10.

The description here assumes that each of the excitation signals outputted from frequency response measurement device 10 is an input torque instruction, but the excitation signals outputted from frequency response measurement device 10 are not necessarily limited to the input torque instruction. The excitation signal may also be, for example, an input speed instruction for specifying the speed of motor 22 or an input position instruction for specifying the position of motor 22.

Frequency response measurement device 10 includes first outputter 11, second outputter 12, frequency response calculator 13, frequency response outputter 15, and excitation signal selector 16, and measures the frequency response of servo system 20.

Frequency response measurement device 10 may be realized, for example, in a computer device including a processor, a memory, and an input/output interface, by means of the processor executing a program stored in the memory.

First outputter 11 includes first measurement condition calculator 111 and first excitation signal generator 112, and outputs a first excitation signal in a first frequency range.

First measurement condition calculator 111 receives an input of total inertia information indicating the total inertia of servo system 20, which is the sum of the inertia of motor 22 and the inertia of load 23, and calculates the amplitude of the first excitation signal on the basis of the total inertia indicated by the inputted total inertia information.

The input of the total inertia information to first measurement condition calculator 111 is realized, for example, by means of the user using frequency response measurement device 10 inputting, to first measurement condition calculator 111, the total inertia information indicating the total inertia calculated from, for example, design information of servo system 20, via, for example, the input/output interface included in frequency response measurement device 10.

When an excitation signal is outputted to servo system 20 to excite vibration, the amplitude of the excitation signal is required to be larger as the total inertia of servo system 20 is larger. For this reason, first measurement condition calculator 111 may also calculate the amplitude of the first excitation signal by, for example, multiplying the total inertia indicated by the total inertia information by a predetermined coefficient.

The description here assumes that first measurement condition calculator 111 receives an input of the total inertia information, and calculates the amplitude of the first excitation signal on the basis of the total inertia indicated by the total inertia information. However, first measurement condition calculator 111 may receive, for example, an input of friction response information indicating the friction response of servo system 20, and calculate the amplitude of the first excitation signal on the basis of the friction response indicated by the friction response information. Alternatively, first measurement condition calculator 111 may receive, for example, an input of the total inertia information and the friction response information, and calculate the amplitude of the first excitation signal on the basis of the total inertia indicated by the total inertia information and the friction response information indicated by the friction response information.

When the amplitude of the first excitation signal is small with respect to the friction torque of load 23, for example, load 23 does not move sufficiently even if the first excitation signal is outputted to servo system 20. This results in the failure of accurately measuring the frequency response of servo system 20. For this reason, by calculating the amplitude of the first excitation signal on the basis of the friction response indicated by the friction response information, it is possible to measure the frequency response of servo system 20 with high accuracy.

When the friction response information indicating the friction torque of load 23 is inputted to first measurement condition calculator 111, first measurement condition calculator 111 may calculate the amplitude of the first excitation signal by, for example, multiplying the friction torque indicated by the friction response information by a predetermined coefficient.

When the total inertia information indicating the total inertia of servo system 20 and the friction response information indicating the friction torque of load 23 are inputted to first measurement condition calculator 111, for example, first measurement condition calculator 111 may calculate, as the amplitude of the first excitation signal, the sum of a value obtained by multiplying the total inertia indicated by the total inertia information by a predetermined coefficient and a value obtained by multiplying the friction torque indicated by the friction response information by a predetermined coefficient.

On the basis of the amplitude of the first excitation signal calculated by first measurement condition calculator 111, first excitation signal generator 112 generates the first excitation signal having such amplitude and outputs the generated first excitation signal to excitation signal selector 16. The description here assumes that the first frequency range is the entire frequency range of the frequency response measured by frequency response measurement device 10. The description here also assumes that the first excitation signal is a torque instruction (first torque instruction) for specifying the torque of motor 22 as described above.

The first excitation signal outputted by first excitation signal generator 112 is any one of a white noise signal, a multi-sine wave signal, a sine wave sweep signal, a step signal, or a ramp signal.

FIG. 2A is a waveform diagram showing an example of the white noise signal. FIG. 2B is a waveform diagram showing an example of the multi-sine wave signal. FIG. 2C is a waveform diagram showing an example of the sine wave sweep signal. FIG. 2D is a waveform diagram showing an example of the step signal. FIG. 2E is a waveform diagram showing an example of the ramp signal.

In FIG. 2A to FIG. 2E, the horizontal axis represents time and the vertical axis represents torque.

The white noise signal illustrated in FIG. 2A is a type of pseudo-random signal and includes, in a substantially uniform manner, all frequency components in the frequency band of 1/2 or lower of the sampling cycle. The white noise signal is characterized in that it includes a wide range of frequency components and its signal generation is easy, although affected by noise in the high frequency band.

The multi-sine wave signal illustrated in FIG. 2B is characterized in that it achieves a strong signal intensity in a frequency range having been set and has a highly uniform frequency spectrum in the entirety of the set frequency range, although it requires the setting of a frequency range and its signal generation is relatively complicated.

The sine wave sweep signal illustrated in FIG. 2C is characterized in that it achieves a strong signal intensity in a frequency range that has been set and has a uniform frequency spectrum in most of the set frequency range, although it requires the setting of a frequency range.

The step signal illustrated in FIG. 2D is characterized in that its signal generation is easy, although the signal intensity is weak in the high frequency band.

The ramp signal illustrated in FIG. 2E is characterized in that its signal generation is easy, although the signal intensity is weak in the high frequency band.

The description here assumes that the first excitation signal outputted by first outputter 11 is the white noise signal.

With reference to FIG. 1 again, the description of frequency response measurement system 1 will be continued.

Excitation signal selector 16 selects one of the first excitation signal outputted from first outputter 11 or the second excitation signal (to be described later) outputted from second outputter 12, and outputs, to servo system 20, the first excitation signal or the second excitation signal that has been selected, as an excitation signal.

Frequency response calculator 13 calculates the frequency response of servo system 20 on the basis of an identification input signal inputted to servo system 20 to obtain the frequency response of servo system 20 and an identification output signal outputted from servo system 20 to obtain the frequency response of servo system 20. In so doing, frequency response calculator 13 performs sampling to obtain the identification input signal and the identification output signal.

Here, the identification input signal may be, for example, an excitation signal itself outputted from frequency response measurement device 10, or may be a control signal that is generated in motor control device 21 on the basis of the excitation signal outputted from frequency response measurement device 10 to drive motor 22. Here, the control signal that is generated in motor control device 21 on the basis of the excitation signal outputted from frequency response measurement device 10 to drive motor 22 may also be, for example, a feedback torque instruction. The description here assumes that the identification input signal is the excitation signal inputted to servo system 20.

The identification output signal may also be, for example, a state signal outputted from first state quantity measurement device 24. The description here assumes that the identification output signal is the state signal outputted from first state quantity measurement device 24.

Stated differently, (1) when the first excitation signal in the first frequency range outputted from frequency response measurement device 10 is inputted to servo system 20, frequency response calculator 13 calculates a first frequency response of servo system 20 in the first frequency range on the basis of the first excitation signal and the first state signal obtained in a first sampling cycle. (2) When the second excitation signal in the second frequency range outputted from frequency response measurement device 10 is inputted to servo system 20, frequency response calculator 13 calculates a second frequency response of servo system 20 in the second frequency range on the basis of the second excitation signal and a second state signal that are obtained in a second sampling cycle that is longer than or equal to the first sampling cycle.

More specifically, (1) when the first excitation signal is inputted to servo system 20, frequency response calculator 13 calculates the first frequency response of servo system 20 in the first frequency range on the basis of: a first input torque instruction outputted from motor control device 21 in servo system 20 to which the first excitation signal is inputted and obtained in the first sampling cycle; and the first state signal outputted from first state quantity measurement device 24 in servo system 20 to which the first excitation signal is inputted and obtained in the first sampling cycle. Also, (2) when the second excitation signal is inputted to servo system 20, frequency response calculator 13 calculates the second frequency response of servo system 20 in the second frequency range on the basis of: a second input torque instruction outputted from motor control device 21 in servo system 20 to which the second excitation signal is inputted and obtained in the second sampling cycle that is longer than or equal to the first sampling cycle; and the second state signal outputted from first state quantity measurement device 24 in servo system 20 to which the second excitation signal is inputted and obtained in the second sampling cycle that is longer than or equal to the first sampling cycle.

The description here assumes that the frequency responses calculated by frequency response calculator 13 are the frequency responses of the rotational speed [rpm] of motor 22 relative to the input torques [Nm] inputted to servo system 20.

FIG. 3 is a Bode plot showing an example of the first frequency response calculated by frequency response calculator 13 when frequency response measurement device 10 outputs the first excitation signal.

In FIG. 3, the horizontal axis represents frequency and the vertical axis represents gain G shown in Expression (1). Here, the responsiveness of the rotational speed relative to the input torque instruction for each frequency is represented as the gain.

[Math. 1]

$$\mathrm{G[d\beta]} \;=\; 20\log_{10}\left(\frac{rotational\ speed\ [rpm]}{input\ torque\ [Nm]}\right) \hspace{4cm} (1)$$

In FIG. 3, the black circles each represent the gain at each frequency calculated on the basis of Expression (1), and the lines are lines resulting from connecting these points.

In FIG. 3, there is a point, within the first frequency range, at which the fluctuations in the gain which has been increasing with respect to an increase in frequency turn to decrease, i.e., a point at which the fluctuations in the gain with respect to an increase in frequency become convex upward. Also, there is a point, within the first frequency range, at which the fluctuations in the gain which has been decreasing with respect to an increase in frequency turn to increase, i.e., a point at which the fluctuations in the gain with respect to an increase in frequency become convex downward. The frequency at such point is the anti-resonance frequency of servo system 20.

The resonance and the anti-resonance of servo system 20 are vibration responses having a significant impact on the operation control performed on motor 22 by motor control device 21. It is thus extremely important in the measurement of the frequency response of servo system 20 to have an accurate grasp of the resonance frequency and the anti-resonance frequency. It is thus desirable to measure the frequency response in the resonance and anti-resonance frequency bands with high accuracy.

The description here assumes that frequency response calculator 13 calculates, as the frequency response, the gain response, which is a type of a Bode plot. However, frequency response calculator 13 is not limited to being configured to output the gain response as the frequency response. For example, frequency response calculator 13 may also calculate, as the frequency response, the phase response, which is another type of Bode plot, or may also calculate both the gain response and the phase response. Frequency response calculator 13 may also be configured to calculate, as the frequency response, a Nyquist plot instead of a Bode plot.

With reference to FIG. 1 again, the description of frequency response measurement system 1 will be continued.

Frequency response calculator 13 may be realized, for example, by means of being configured to include Fourier transformer 17 and frequency response arithmetic unit 18, as shown in FIG. 1. Here, Fourier transformer 17 performs a Fourier transform on an input torque instruction outputted from motor control device 21 and the rotational speed of motor 22 obtained by time-differentiating a state signal indicating the rotational position of motor 22 outputted from first state quantity measurement device 24. Frequency response arithmetic unit 18 calculates the gain of the rotational speed relative to the input torque instruction for each frequency component by substituting, into Expression (1), the input torque instruction for each frequency component and the rotational speed for each frequency component that have been Fourier-transformed by Fourier transformer 17.

Second outputter 12 includes second measurement condition calculator 121 and second excitation signal generator 122, and outputs the second excitation signal in the second frequency range that forms a part of the first frequency range.

This second excitation signal can be used, for example, as an excitation signal for re-measuring the frequency response of servo system 20 in the vicinity of the resonance frequency or the anti-resonance frequency in a more detailed and accurate manner.

With reference to FIG. 4, the following describes the reason that the accuracy of the frequency response shown in FIG. 3 can be insufficient as the frequency response in the vicinity of the resonance frequency or the anti-resonance frequency.

FIG. 4 is a Bode plot showing an example of the frequency response calculated by frequency response calculator 13 when frequency response measurement device 10 outputs an excitation signal.

In FIG. 4, the intervals between diagonally shaded circles and the intervals between black circles are the frequency resolutions in the calculation of the frequency response.

Here, the diagonally shaded circles are the same as the black circles in FIG. 3. Meanwhile, the black circles represent an example of the frequency response calculated by frequency response calculator 13 when the frequency resolution is set to be higher with respect to the diagonally shaded circles.

It can be seen that the point at which the fluctuations in the gain become convex downward in the black circles in FIG. 4, i.e., the anti-resonance frequency, differs from the anti-resonance frequency in the diagonally shaded circles. The reason is that, since the frequency resolution of the frequency response represented by the diagonally shaded circles differs from the frequency resolution of the frequency response represented by the black circles, and the frequency resolution represented by the diagonally shaded circles is lower than the frequency resolution represented by the black circles, the accuracy of the anti-resonance frequency in the frequency response represented by the diagonally shaded circles is lower than the accuracy of the anti-resonance frequency in the frequency response represented by the black circles. Stated differently, in this case, to accurately calculate the resonance frequency and the anti-resonance frequency, it is necessary to set the frequency resolution to be high.

The second excitation signal is an excitation signal for obtaining the frequency response with a frequency resolution that is higher than or equal to the frequency resolution of the first excitation signal. In general, a frequency resolution is a value obtained by dividing the sampling frequency, which is the inverse of the sampling cycle, by the number of measurement data points. The number of data points is determined by the capacity constraints of a memory that stores the measured data. For this reason, to obtain a frequency response with a higher frequency resolution, it is necessary to generate, as the second excitation signal, an excitation signal in a sampling cycle that is longer than or equal to the sampling cycle of the first excitation signal. In addition, to further increase the signal intensity, the frequency band to be measured is narrowed, that is, the second frequency range is set to be a part of the first frequency range. The description here assumes that the second frequency range is determined in advance.

With reference to FIG. 1 again, the description of frequency response measurement system 1 will be continued.

Second measurement condition calculator 121 receives an input of the first frequency response calculated by frequency response calculator 13 and calculates the amplitude of the second excitation signal on the basis of such inputted first frequency response. Second measurement condition calculator 121 may also receive an input of the total inertia information.

With reference to FIG. 5, the following describes an example of the method of calculating the amplitude of the second excitation signal performed by second measurement condition calculator 121.

FIG. 5 is a Bode plot showing the frequency response of servo system 20 overlaid on the first frequency response shown in FIG. 3, when servo system 20 is approximated as a rigid body (hereinafter "rigid-body approximated servo system 20").

Here, "the frequency response of rigid-body approximated servo system 20" refers to the frequency response calculated only from the inertia of motor 22 and the inertia of load 23, when assuming that servo system 20 is an ideal servo system without resonance or anti-resonance.

It is possible to calculate such frequency response of rigid-body approximated servo system 20 from the total inertia indicated by the total inertia information.

Second measurement condition calculator 121 compares the first frequency response with the frequency response of rigid-body approximated servo system 20 in the second frequency range. Then, for a frequency band in which the gain of the first frequency response is smaller than the gain of rigid-body approximated servo system 20, second measurement condition calculator 121 calculates the amplitude of the second excitation signal such that the amplitude of the second excitation signal becomes larger than the amplitude of the first excitation signal. For a frequency band in which the gain of the second frequency response is larger than the gain of rigid-body approximated servo system 20, second measurement condition calculator 121 calculates the amplitude of the second excitation signal such that the amplitude of the second excitation signal becomes smaller than the amplitude of the first excitation signal.

Second measurement condition calculator 121 may calculate the amplitude of the second excitation signal by, for example, multiplying the amplitude of the first excitation signal by the ratio between the gain of the first frequency response and the gain of rigid-body approximated servo system 20.

On the basis of the amplitude of the second excitation signal calculated by second measurement condition calculator 121, second excitation signal generator 122 generates the second excitation signal having such amplitude and outputs the generated second excitation signal to excitation signal selector 16. The description here assumes that the second excitation signal is a torque instruction (second torque instruction) for specifying the torque of motor 22, as in the case of the first excitation signal.

The second excitation signal outputted by second excitation signal generator 122 is any one of a multi-sine wave signal or a sine wave sweep signal.

As described above, these two signals are signals that allow the setting of a frequency range. For this reason, even when the amplitude of the first excitation signal and the amplitude of the second excitation signal are the same as a result of narrowing the frequency range of the white noise signal used as the first excitation signal, the signal intensity of the second excitation signal is higher than signal intensity of the first excitation signal in the second frequency range. It becomes thus possible to obtain, in the second frequency range, the second frequency response that exhibits the frequency response with further higher accuracy than the first frequency response.

The description here assumes that the second excitation signal outputted by second outputter 12 is a multi-sine wave signal. The reason for using a multi-sine wave signal as the second excitation signal is that, compared to a sine wave sweep signal, a multi-sine wave signal is characterized in that it has a highly uniform frequency spectrum in the entirety of the specified frequency range, which fulfills the purpose of measuring the frequency response with higher accuracy in the specified frequency range.

With reference to FIG. 1 again, the description of frequency response measurement system 1 will be continued.

When receiving an input of the second excitation signal from second outputter 12, excitation signal selector 16 outputs the second excitation signal to servo system 20.

As described above, when the second excitation signal is inputted to servo system 20, frequency response calculator 13 calculates the second frequency response.

FIG. 6 is a Bode plot showing an example of the second frequency response calculated by frequency response calculator 13 when frequency response measurement device 10 outputs the second excitation signal.

In FIG. 6, the horizontal axis represents frequency and the vertical axis represents gain G shown in Expression (1). In FIG. 6, the dashed lines represent an example of the first frequency response calculated by frequency response calculator 13 when frequency response measurement device 10 outputs the first excitation signal and is the same as the first frequency response illustrated in FIG. 3.

As shown in FIG. 6, frequency response calculator 13 calculates the second frequency response with a higher frequency resolution than the frequency resolution with which the first frequency response is calculated.

With reference to FIG. 1 again, the description of frequency response measurement system 1 will be continued.

Frequency response outputter 15 outputs, to outside, the first frequency response, the second frequency response, or both the first frequency response and the second frequency response calculated by frequency response calculator 13.

Frequency response outputter 15 may output these frequency responses to outside, for example, in accordance with an operation inputted by the user using frequency response measurement device 10 via, for example, the input/output interface included in frequency response measurement device 10.

Frequency response outputter 15 may output these frequency responses to, for example, an external display device, and such external display device may generate and display an image that is based on these frequency responses outputted from frequency response outputter 15. In this case, it is possible for the user using frequency response measurement device 10 to have a grasp of the frequency response of servo system 20 by viewing the image displayed on the external display device.

<Operation>

The following describes the operation performed by frequency response measurement device 10 having the above configuration.

Frequency response measurement device 10 performs first frequency response measurement processing for measuring the frequency response of servo system 20. The first frequency response measurement processing is started, for example, by the user using frequency response measurement system 1 performing, on frequency response measurement device 10, an operation for starting the first frequency response measurement processing.

FIG. 7 is a flowchart of the first frequency response measurement processing performed by frequency response measurement device 10.

As shown in FIG. 7, upon the start of the first frequency response measurement processing, first outputter 11 generates the first excitation signal in the first frequency range and outputs such generated first excitation signal to servo system 20 via excitation signal selector 16 (step S10).

Next, frequency response calculator 13 calculates the first frequency response on the basis of the first identification input signal and the first identification output signal obtained in the first sampling cycle from servo system 20 to which the first excitation signal is inputted (step S20).

When the first frequency response is calculated, second outputter 12 outputs, to servo system 20, the second excitation signal in the second frequency range that forms a part of the first frequency range via excitation signal selector 16 on the basis of the first frequency response (step S30).

Next, frequency response calculator 13 calculates the second frequency response on the basis of the second identification input signal and the second identification output signal obtained in the second sampling cycle that is longer than or equal to the first sampling cycle from servo system 20 to which the second excitation signal is inputted (step S40).

When the second frequency response is calculated, frequency response outputter 15 outputs, to outside, the first frequency response, the second frequency response, or both the first frequency response and the second frequency response (step S50).

When the process of step S50 is completed, frequency response measurement device 10 terminates the first frequency response measurement processing.

<Consideration>

Frequency response measurement device 10 having the above configuration first calculates the first frequency response of servo system 20 using the first excitation signal in the first frequency range that is subjected to frequency response measurement, thereby grasping an overall perspective of the frequency response of servo system 20. Then, using the second excitation signal in the second frequency range that forms a part of the first frequency range, frequency response measurement device 10 calculates, in a further detailed and accurate manner, the second frequency response of servo system 20 in such second frequency range in the second sampling cycle that is longer than or equal to the first sampling cycle.

With this, according to frequency response measurement device 10 having the above configuration, it is possible to obtain a highly accurate frequency response of servo system 20, even when servo system 20 is a system with a relatively large inertia or a relatively large friction, or with resonance or anti-resonance in the frequency response of servo system 20.

The description of Embodiment 1 assumes that the first excitation signal and the second excitation signal are used as the first identification input signal and the second identification input signal, respectively, in calculating the frequency responses. However, the first identification input signal and the second identification input signal do not necessarily have to be the first excitation signal and the second excitation signal, respectively. When the first excitation signal and the second excitation signal are input speed instructions, for example, Embodiment 1 may also be configured to use feedback torque instructions as the first identification input signal and the second identification input signal. With such configuration, when frequency response measurement device 10 outputs the first excitation signal and the second excitation signal, it is possible to obtain the frequency responses of the motor speed relative to the motor torque of servo motor 20 that are not affected by the speed control on motor 22 while the speed state of motor 22 is under control.

In the description of Embodiment 1, the frequency resolution of the second frequency response becomes higher than or equal to the frequency resolution of the first frequency response by setting the second sampling cycle to be longer than or equal to the first sampling cycle.

In contrast, the following describes the reason that the accuracy of the second frequency response becomes higher than the accuracy of the first frequency response if the second frequency range is narrower than the first frequency range, in particular, even when the second sampling frequency is equal to the first sampling frequency, i.e., the frequency resolution of the second frequency response is equal to the frequency resolution of the first frequency response.

FIG. 8 is a diagram for describing the reason that the accuracy of the second frequency response becomes higher than the accuracy of the first frequency response if the second frequency range is narrower than the first frequency range, even when the frequency resolution of the second frequency response is equal to the frequency resolution of the first frequency response.

Portion (A1) in FIG. 8 is a diagram showing time-series data of the white noise signal serving as the first excitation signal. In the diagram, the horizontal axis represents time and the vertical axis represents state quantity (torque).

Portion (B1) in FIG. 8 is a diagram showing time-series data of the multi-sine wave signal serving as the second excitation signal. In the diagram, the horizontal axis represents time and the vertical axis represents state quantity (torque).

The description here assumes that the amplitude of the first excitation signal in the time-series data is equal to the amplitude of the second excitation signal in the time-series data.

Portion (A2) in FIG. 8 is a diagram showing the frequency components of the first excitation signal obtained by Fourier-transforming the first excitation signal. In the diagram, the horizontal axis represents frequency and the vertical axis represents gain. The gain of the excitation signal indicates the signal intensity of the excitation signal, and the larger the gain, the larger the signal intensity.

Portion (B2) in FIG. 8 is a diagram showing the frequency components of the second excitation signal obtained by Fourier-transforming the second excitation signal. In the diagram, the horizontal axis represents frequency and the vertical axis represents gain.

As can be seen from the comparison between the diagram of portion (B1) and the diagram of portion (B2), the range of frequency components included in the second excitation signal is narrower than the range of frequency components included in the first excitation signal, while the signal intensity of the second excitation signal is higher than the signal intensity of the first excitation signal.

As described above, even when the frequency resolution of the second frequency response is equal to the frequency resolution of the first frequency response, it is possible to make the signal intensity of the second excitation signal higher than the signal intensity of the first excitation signal in the second frequency range, by making the second frequency range narrower than the first frequency range. For this reason, the accuracy of the second frequency response becomes higher than the accuracy of the first frequency response in the second frequency range.

In the description of Embodiment 1, first measurement condition calculator 111 calculates the amplitude of the first excitation signal on the basis of at least one of the total inertia or the friction response. In contrast, first measurement condition calculator 111 may also calculate the amplitude of the first excitation signal further on the basis of the control parameters of servo system 20, in addition to at least one of the total inertia or the friction response. With this, it is possible for first measurement condition calculator 111 to calculate a more appropriate amplitude of the first excitation signal.

In the description of Embodiment 1, second measurement condition calculator 121 calculates the amplitude of the second excitation signal on the basis of the second frequency response. In contrast, second measurement condition calculator 121 may also calculate the amplitude of the first excitation signal further on the basis of the control parameters of servo system 20, in addition to the first frequency response. With this, it is possible for second measurement condition calculator 121 to calculate a more appropriate amplitude of the second excitation signal.

Note that in Embodiment 1, the first identification input signal and the second identification input signal may have an equal sampling number. With this, it is possible to use, as a common storage region, a storage region for storing the first identification input signal and a storage region for storing the second identification signal. This eliminates the necessity of securing an additional storage region for storing the identification input signals.

[Embodiment 2]

The following describes a frequency response measurement system according to Embodiment 2, which is configured by changing some of the elements of frequency response measurement system 1 according to Embodiment 1.

The following describes the frequency response measurement system according to Embodiment 2, focusing on the differences from frequency response measurement system 1. In the following description, the same reference signs are assigned to the same elements as those of frequency response measurement system 1 and detailed description of the same elements, which have already been described, are omitted.

FIG. 9 is a block diagram showing the configuration of frequency response measurement system 1A according to Embodiment 2.

As shown in FIG. 9, frequency response measurement system 1A is configured by being changed from frequency response measurement system 1 according to Embodiment 1; frequency response measurement device 10 is replaced by frequency response measurement device 10A. Also, frequency response measurement device 10 A is configured by being changed from frequency response measurement device 10 according to Embodiment 1; excitation signal selector 16 is replaced by excitation signal selector 16A, frequency response outputter 15 is replaced by frequency response synthesizer 19, and third outputter 14 is added.

Third outputter 14 includes third measurement condition calculator 141 and third excitation signal generator 142. Third outputter 14 outputs a third excitation signal in a third frequency range that forms a part of the first frequency range and is a range defined by a first frequency that is higher than the lower limit frequency in the second frequency range and a second frequency that is higher than or equal to the upper limit frequency in the second frequency. Here, the second frequency range and the third frequency range may be continuous, and the lower limit frequency in the third frequency range may be within the second frequency range, i.e., a part of the second frequency range and a part of the third frequency range may overlap. The description here assumes that a part of the second frequency range and a part of the third frequency range overlap.

The third excitation signal is an excitation signal for obtaining the frequency response with a frequency resolution that is higher than the frequency resolution of the first excitation signal, as in the case of the second excitation signal.

Third measurement condition calculator 141 receives an input of the first frequency response calculated by frequency response calculator 13 and calculates the amplitude of the third excitation signal on the basis of such inputted first frequency response. Third measurement condition calculator 141 may also receive an input of the total inertia information.

The method of calculating the amplitude of the third excitation signal performed by third measurement condition calculator 141 is the same as the method of calculating the amplitude of the second excitation signal performed by second measurement condition calculator 121.

On the basis of the amplitude of the third excitation signal calculated by third measurement condition calculator 141, third excitation signal generator 142 generates the third excitation signal having such amplitude and outputs the generated third excitation signal to excitation signal selector 16A. The description here assumes that the third excitation signal is a torque instruction (third torque instruction) for specifying the torque of motor 22, as in the case of the first excitation signal and the second excitation signal.

The third excitation signal outputted by third excitation signal generator 142 is any one of a multi-sine wave signal or a sine wave sweep signal.

As described above, these two signals are signals that allow the setting of a frequency range. For this reason, even when the amplitude of the first excitation signal and the amplitude of the third excitation signal are the same as a result of narrowing the frequency range of the white noise signal used as the first excitation signal, the signal intensity of the third excitation signal is higher than the signal intensity of the first excitation signal in the third frequency range. It becomes thus possible to obtain, in the third frequency range, a third frequency response that exhibits the frequency response with further higher accuracy than the first frequency response.

The description here assumes that the third excitation signal outputted by third outputter 14 is a multi-sine wave signal.

Excitation signal selector 16A selects one of the first excitation signal outputted from first outputter 11, the second excitation signal outputted from second outputter 12, and the third excitation signal outputted from third outputter 14, and outputs, to servo system 20, the first excitation signal, the second excitation signal, or the third excitation signal that has been selected, as an excitation signal.

When the third excitation signal in the third frequency range outputted from frequency response measurement device 10A is inputted to servo system 20, frequency response calculator 13 calculates the third frequency response of servo system 20 in the third frequency range on the basis of the third excitation signal and a third state signal obtained in a third sampling cycle.

More specifically, when the third excitation signal is inputted to servo system 20, frequency response calculator 13 calculates the third frequency response of servo system 20 in the third frequency range on the basis of: a third input torque instruction outputted from motor control device 21 in servo system 20 to which the third excitation signal is inputted and obtained in the third sampling cycle; and the third state signal outputted from first state quantity measurement device 24 in servo system 20 to which the first excitation signal is inputted and obtained in the third sampling cycle.

FIG. 10 is a Bode plot showing an example of the third frequency response calculated by frequency response calculator 13 when frequency response measurement device 10A outputs the third excitation signal.

In FIG. 10, the horizontal axis represents frequency and the vertical axis represents gain G shown in Expression (1). In FIG. 10, the long dashed lines represent an example of the first frequency response calculated by frequency response calculator 13 when frequency response measurement device 10A outputs the first excitation signal and is the same as the first frequency response illustrated in FIG. 3, and the short dashed lines represent an example of the second frequency response calculated by frequency response calculator 13 when frequency response measurement device 10A outputs the second excitation signal and is the same as the second frequency response illustrated in FIG. 6.

As shown in FIG. 10, frequency response calculator 13 calculates the third frequency response with a higher frequency resolution than the frequency resolution with which the first frequency response is calculated.

With reference to FIG. 9 again, the description of frequency response measurement system 1A will be continued.

Frequency response synthesizer 19 calculates a fourth frequency response of servo system 20 by synthesizing the second frequency response and the third frequency response. Then, frequency response synthesizer 19 outputs, to outside, at least one of the second frequency response, the third frequency response, or the fourth frequency response.

FIG. 11 is a Bode plot showing an example of the fourth frequency response synthesized by frequency response synthesizer 19.

As shown in FIG. 10 and FIG. 11, frequency response synthesizer 19 calculates, for example, the second frequency response and the third frequency response as they are as the fourth frequency response for the part in the second frequency range and the third frequency range that does not overlap.

Frequency response synthesizer 19 calculates, for example, the average of the second frequency response and the third frequency response as the fourth frequency response for the part in the second frequency range and the third frequency range that overlaps.

Frequency response synthesizer 19 may output these frequency responses to outside, for example, in accordance with an operation inputted by the user using frequency response measurement device 10A via, for example, the input/output interface included in frequency response measurement device 10A.

Frequency response synthesizer 19 may output these frequency responses to, for example, an external display device, and such external display device may generate and display an image that is based on these frequency responses outputted from frequency response synthesizer 19. In this case, it is possible for the user using frequency response measurement device 10A to have a grasp of the frequency response of servo system 20 by viewing the image displayed on the external display device.

<Operation>

The following describes the operation performed by frequency response measurement device 10A having the above configuration.

Instead of the first frequency response measurement processing performed by frequency response measurement device 10 according to Embodiment 1, frequency response measurement device 10A performs second frequency response measurement processing whose processes are partially different from the processes of the first frequency response measurement processing.

FIG. 12 is a flowchart of the second frequency response measurement processing performed by frequency response measurement device 10A.

Of the processes of the second frequency response measurement processing, the process of step S110 to the process of step S140 are the same as the process of step S10 to the process of step S40 in the first frequency response measurement processing, when excitation signal selector 16 is read as excitation signal selector 16A.

The description here thus focuses on the process of step S150 to the process of step S170.

When the process of step S140 is completed, third outputter 14 outputs, to servo system 20, the third excitation signal in the third frequency range, which forms a part of the first frequency range and is a range defined by the first frequency that is higher than the lower limit frequency in the second frequency range and the second frequency that is higher than or equal to the upper limit frequency in the second frequency, via excitation signal selector 16 (step S150).

Next, frequency response calculator 13 calculates the third frequency response on the basis of a third identification input signal and a third identification output signal obtained from servo system 20 to which the third excitation signal is inputted, in the third sampling cycle that is longer than or equal to the first sampling cycle (step S160).

When the third frequency response is calculated, frequency response synthesizer 19 calculates the fourth frequency response of servo system 20 by synthesizing the second frequency response and the third frequency response, and outputs the calculated fourth frequency response to outside (step S170).

When the process of step S170 is completed, frequency response measurement device 10A terminates the second frequency response measurement processing.

<Consideration>

According to frequency response measurement device 10A having the above configuration, it is possible to obtain a highly accurate frequency response of servo system 20, even when servo system 20 is a system with a relatively large inertia or a relatively large friction, or with resonance or anti-resonance in the frequency response of servo system 20, as in the case of frequency response measurement device 10 according to Embodiment 1.

In the description of the method of calculating the amplitude of the second excitation signal performed by second measurement condition calculator 121 and the method of calculating the amplitude of the third excitation signal performed by third measurement condition calculator 141 in Embodiment 1 and Embodiment 2, an example case has been described in which the second frequency range or the third frequency range includes the resonance frequency or/and the anti-resonant frequency. However, it is possible to use the same calculation methods to calculate the amplitude of the second addition signal and the amplitude of the third excitation signal, even when the second frequency range or the third frequency range does not include the resonance frequency and the anti-resonant frequency.

FIG. 13 is a Bode plot in which the frequency response of servo system 20 is overlaid on the first frequency response shown in FIG. 3, when servo system 20 is approximated as a rigid body (hereinafter "rigid-body approximated servo system 20") and the second frequency range does not include the resonance frequency and the anti-resonance frequency.

As shown in FIG. 13, even when the second frequency range does not include the resonance frequency and the anti-resonance frequency, a gain difference occurs between the first frequency response and the frequency response of rigid-body approximated servo system 20. For this reason, second measurement condition calculator 121 is capable of calculating the amplitude of the second excitation signal using the same calculation method even when the second frequency range does not include the resonance frequency and the anti-resonance frequency, and third measurement condition calculator 141 is capable of calculating the amplitude of the third excitation signal using the same calculation method even when the third frequency range does not include the resonance frequency and the anti-resonance frequency.

[Variation 1]

The following describes a frequency response measurement system according to Variation 1, which is configured by changing some of the elements of frequency response measurement system 1A according to Embodiment 2.

Frequency response measurement system 1A is an example of the configuration in which the frequency response of servo system 20 related to the state quantity of motor 22 is measured. In contrast, the frequency response measurement system according to Variation 1 is an example of the configuration in which the frequency response of servo system 20B (to be described later) according to Variation 1 related to the state quantity of load 23, which is the target to be driven, is measured.

The following describes the frequency response measurement system according to Variation 1, focusing on the differences from frequency response measurement system 1A. In the following description, the same reference signs are assigned to the same elements as those of frequency response measurement system 1A and detailed description of the same elements, which have already been described, are omitted.

FIG. 14 is a block diagram showing the configuration of frequency response measurement system 1B according to Variation 1.

As shown in FIG. 14, frequency response measurement system 1B is configured by being changed from frequency response measurement system 1A according to Embodiment 2; frequency response measurement device 10A is replaced by frequency response measurement device 10B and servo system 20 is replaced by servo system 20B. Also, frequency response measurement device 10B is configured by being changed from frequency response measurement device 10A; frequency response calculator 13 is replaced by frequency response calculator 13B and Fourier transformer 17 is replaced by Fourier transformer 17B. In addition, servo system 20B is configured to additionally include second state quantity measurement device 25 compared to servo system 20.

Second state quantity measurement device 25 measures the state quantity related to load 23, which is the target to be driven in servo system 20B, and outputs the measured state quantity related to load 23 as a state signal indicating the state quantity of servo system 20B. The description here assumes that second state quantity measurement device 25 is a sensor that outputs the state quantity related to load 23 by sensing load 23. Stated differently, the state signal outputted by second state quantity measurement device 25 includes sensor information indicating the state quantity of load 23 obtained by sensing load 23, which is the target to be driven in servo system 20B. More specifically, the description here assumes that second state quantity measurement device 25 is a sensor that measures the rotational position of load 23 and outputs a state signal indicating the rotational position of load 23. However, second state quantity measurement device 25 is not necessarily limited to the above sensor, as long as second state quantity measurement device 25 is a device capable of measuring the state quantity related to load 23 and outputting the measured state quantity related to load 23.

Frequency response calculator 13B calculates the frequency response of servo system 20B on the basis of an identification input signal inputted to servo system 20B to obtain the frequency response of servo system 20B and an identification output signal outputted from servo system 20B to obtain the frequency response of servo system 20B. In so doing, frequency response calculator 13B performs sampling to obtain the identification input signal and the identification output signal.

Here, the identification input signal may be, for example, an excitation signal itself outputted from frequency response measurement device 10B, or may be a control signal that is generated in motor control device 21 on the basis of the excitation signal outputted from frequency response measurement device 10B to drive motor 22. Here, the control signal that is generated in motor control device 21 on the basis of the excitation signal outputted from frequency response measurement device 10B to drive motor 22 may be, for example, a feedback torque instruction. The description here assumes that the identification input signal is the excitation signal inputted to servo system 20B.

The identification output signal may be, for example, a state signal outputted from second state quantity measurement device 25. The description here assumes that the identification output signal is the state signal outputted from second state quantity measurement device 25.

Stated differently, (1) when the first excitation signal in the first frequency range outputted from frequency response measurement device 10B is inputted to servo system 20B, frequency response calculator 13B calculates the first frequency response of servo system 20B in the first frequency range on the basis of the first excitation signal and the first state signal obtained in the first sampling cycle. (2) When the second excitation signal in the second frequency range outputted from frequency response measurement device 10B is inputted to servo system 20B, frequency response calculator 13B calculates the second frequency response of servo system 20B in the second frequency range on the basis of the second excitation signal and the second state signal that are obtained in the second sampling cycle that is longer than or equal to the first sampling cycle. (3) When the third excitation signal in the third frequency range outputted from frequency response measurement device 10B is inputted to servo system 20B, frequency response calculator 13B calculates the third frequency response of servo system 20B in the third frequency range on the basis of the third excitation signal and the third state signal that are obtained in the third sampling cycle that is longer than or equal to the first sampling cycle.

More specifically, (1) when the first excitation signal is inputted to servo system 20B, frequency response calculator 13B calculates the first frequency response of servo system 20B in the first frequency range on the basis of: the first input torque instruction outputted from motor control device 21 in servo system 20B to which the first excitation signal is inputted and obtained in the first sampling cycle; and the first state signal outputted from second state quantity measurement device 25 in servo system 20B to which the first excitation signal is inputted and obtained in the first sampling cycle. Also, (2) when the second excitation signal is inputted to servo system 20B, frequency response calculator 13B calculates the second frequency response of servo system 20B in the second frequency range on the basis of: the second input torque instruction outputted from motor control device 21 in servo system 20B to which the second excitation signal is inputted and obtained in the second sampling cycle that is longer than or equal to the first sampling cycle; and the second state signal outputted from second state quantity measurement device 25 in servo system 20B to which the second excitation signal is inputted and obtained in the second sampling cycle that is longer than or equal to the first sampling cycle. (3) When the third excitation signal is inputted to servo system 20B, frequency response calculator 13B calculates the third frequency response of servo system 20B in the third frequency range on the basis of: the third input torque instruction outputted from motor control device 21 in servo system 20B to which the third excitation signal is inputted and obtained in the third sampling cycle that is longer than or equal to the first sampling cycle; and the third state signal outputted from second state quantity measurement device 25 in servo system 20B to which the third excitation signal is inputted and obtained in the third sampling cycle that is longer than or equal to the first sampling cycle.

The description here assumes that the frequency responses calculated by frequency response calculator 13B are the frequency responses of the rotational speed [rpm] of load 23 relative to the input torques [Nm] inputted to servo system 20B.

Frequency response calculator 13B may be realized, for example, by means of being configured to include Fourier transformer 17B and frequency response arithmetic unit 18, as shown in FIG. 14. Here, Fourier transformer 17B performs a Fourier transform on an input torque instruction outputted from motor control device 21 and the rotational speed of load 23 obtained by time-differentiating a state signal indicating the rotational position of load 23 outputted from second state quantity measurement device 25.

<Consideration>

In general, it is extremely useful in, for example, controlling and adjusting servo system 20B to have a grasp of the frequency response related to the state quantity of load 23 relative to the state quantity instruction (e.g., torque instruction) to motor 22. In view of this, frequency response measurement device 10B having the above configuration is capable of accurately measuring such frequency response. Frequency response measurement device 10B having the above configuration is thus extremely useful in, for example, controlling and adjusting servo system 20B.

[Variation 2]

The following describes a frequency response measurement system according to Variation 2, which is configured by changing some of the elements of frequency response measurement system 1A according to Embodiment 2.

Frequency response measurement system 1A is an example of the configuration in which the frequency response related to the state quantity of motor 22 of servo system 20 is measured. In contrast, the frequency response measurement system according to Variation 2 is an example of the configuration in which the frequency response of servo system 20C (to be described later) according to Variation 2 related to the state quantity of motor 22 and the frequency response of servo system 20C related to the state quantity of load 23, which is the target to be driven, are measured.

The following describes the frequency response measurement system according to Variation 2, focusing on the differences from frequency response measurement system 1A. In the following description, the same reference signs are assigned to the same elements as those of frequency response measurement system 1A and detailed description of the same elements, which have already been described, are omitted.

FIG. 15 is a block diagram showing the configuration of frequency response measurement system 1C according to Variation 2.

As shown in FIG. 15, frequency response measurement system 1C is configured by being changed from frequency response measurement system 1A according to Embodiment 2; frequency response measurement device 10A is replaced by frequency response measurement device 10C and servo system 20 is replaced by servo system 20C. Also, frequency response measurement device 10C is configured by being changed from frequency response measurement device 10A; frequency response calculator 13 is replaced by frequency response calculator 13C and Fourier transformer 17 is replaced by Fourier transformer 17C. In addition, servo system 20C is configured to additionally include second state quantity measurement device 25 compared to servo system 20.

Frequency response calculator 13C calculates the frequency response of servo system 20C related to motor 22 (hereinafter "motor frequency response") and the frequency response of servo system 20C related to load 23 (hereinafter "load frequency response"), on the basis of identification input signals inputted to servo system 20C to obtain the frequency responses of servo system 20C and identification output signals outputted from servo system 20C to obtain the frequency responses of servo system 20C. In so doing, frequency response calculator 13C performs sampling to obtain the identification input signals and the identification output signals.

Here, each of the identification input signals may be, for example, an excitation signal itself outputted from frequency response measurement device 10C, or may be a control signal that is generated in motor control device 21 on the basis of the excitation signal outputted from frequency response measurement device 10C to drive motor 22. Here, the control signal that is generated in motor control device 21 on the basis of the excitation signal outputted from frequency response measurement device 10C to drive motor 22 may also be, for example, a feedback torque instruction. The description here assumes the each of the identification input signals is the excitation signal inputted to servo system 20C.

The identification output signals may be, for example, a state signal indicating the state quantity related to motor 22 (hereinafter "motor state signal") outputted from first state quantity measurement device 24 and a state signal indicating the state quantity related to load 23 (hereinafter "load state signal"). The description here assumes that the identification output signals are the motor state signal outputted from first state quantity measurement device 24 and the load state signal outputted from second state quantity measurement device 25.

Stated differently, (1) when the first excitation signal in the first frequency range outputted from frequency response measurement device 10C is inputted to servo system 20C, frequency response calculator 13C calculates a first motor frequency response of servo system 20C in the first frequency range on the basis of the first excitation signal and a first motor state signal that are obtained in the first sampling cycle, and calculates a first load frequency response of servo system 20C in the first frequency range on the basis of the first excitation signal and a first load state signal that are obtained in the first sampling cycle. (2) When the second excitation signal in the second frequency range outputted from frequency response measurement device 10C is inputted to servo system 20C, frequency response calculator 13C calculates a second motor frequency response of servo system 20C in the second frequency range on the basis of the second excitation signal and a second motor state signal that are obtained in the second sampling cycle that is longer than or equal to the first sampling cycle, and calculates a second load frequency response of servo system 20C in the second frequency range on the basis of the second excitation signal and a second load state signal that are obtained in the second sampling cycle. (3) When the third excitation signal in the third frequency range outputted from frequency response measurement device 10C is inputted to servo system 20C, frequency response calculator 13C calculates a third motor frequency response of servo system 20C in the third frequency range on the basis of the third excitation signal and a third motor state signal that are obtained in the third sampling cycle that is longer than or equal to the first sampling cycle, and calculates a third load frequency response of servo system 20C in the third frequency range on the basis of the third excitation signal and a third load state signal that are obtained in the third sampling cycle.

More specifically, (1) when the first excitation signal is inputted to servo system 20C, frequency response calculator 13C calculates the first motor frequency response of servo system 20C in the first frequency range on the basis of: the first input torque instruction outputted from motor control device 21 in servo system 20C to which the first excitation signal is inputted and obtained in the first sampling cycle; and the first motor state signal outputted from first state quantity measurement device 24 in servo system 20C to which the first excitation signal is inputted and obtained in the first sampling cycle, and calculates the first load frequency response of servo system 20C in the first frequency range on the basis of: the first input torque instruction outputted from motor control device 21 in servo system 20C to which the first excitation signal is inputted and obtained in the first sampling cycle; and the first load state signal outputted from second state quantity measurement device 25 in servo system 20C to which the first excitation signal is inputted and obtained in the first sampling cycle. (2) When the second excitation signal is inputted to servo system 20C, frequency response calculator 13C calculates the second motor frequency response of servo system 20C in the second frequency range on the basis of: the second input torque instruction outputted from motor control device 21 in servo system 20C to which the second excitation signal is inputted and obtained in the second sampling cycle that is longer than or equal to the first sampling cycle; and the second motor state signal outputted from first state quantity measurement device 24 in servo system 20C to which the second excitation signal is inputted and obtained in the second sampling cycle, and calculates the second load frequency response of servo system 20C in the second frequency range on the basis of: the second input torque instruction outputted from motor control device 21 in servo system 20C to which the second excitation signal is inputted and obtained in the second sampling cycle; and the second load state signal outputted from second state quantity measurement device 25 in servo system 20C to which the second excitation signal is inputted and obtained in the second sampling cycle. (3) When the third excitation signal is inputted to servo system 20C, frequency response calculator 13C calculates the third motor frequency response of servo system 20C in the third frequency range on the basis of: the third input torque instruction outputted from motor control device 21 in servo system 20C to which the third excitation signal is inputted and obtained in the third sampling cycle that is longer than or equal to the first sampling cycle; and the third motor state signal outputted from first state quantity measurement device 24 in servo system 20C to which the third excitation signal is inputted and obtained in the third sampling cycle, and calculates the third load frequency response of servo system 20C in the third frequency range on the basis of: the third input torque instruction outputted from motor control device 21 in servo system 20C to which the third excitation signal is inputted and obtained in the third sampling cycle; and the third load state signal outputted from second state quantity measurement device 25 in servo system 20C to which the third excitation signal is inputted and obtained in the third sampling cycle.

The description here assumes that the motor frequency responses calculated by frequency response calculator 13C are the frequency responses of the rotational speed [rpm] of motor 22 relative to the input torques [Nm] inputted to servo system 20C, and that the load frequency responses calculated by frequency response calculator 13C are the frequency responses of the rotational speed [rpm] of load 23 relative to the input torques [Nm] inputted to servo system 20C.

Frequency response calculator 13C may be realized, for example, by means of being configured to include Fourier transformer 17C and frequency response arithmetic unit 18, as shown in FIG. 15. Here, Fourier transformer 17C performs a Fourier transform on: an input torque instruction outputted from motor control device 21; the rotation speed of motor 22 obtained by time-differentiating a state signal indicating the rotational position of motor 22 outputted from first state quantity measurement device 24; and the rotation speed of load 23 obtained by time-differentiating a state signal indicating the rotational position of load 23 outputted from second state quantity measurement device 25.

<Consideration>

According to frequency response measurement device 10C having the above configuration, it is possible to accurately measure the frequency response of servo system 20C related to the state quantity of motor 22 and the frequency response of servo system 20C related to the state quantity of load 23, which is the target to be driven.

[Variation 3]

The following describes a frequency response measurement system according to Variation 3, which is configured by changing some of the elements of frequency response measurement system 1A according to Embodiment 2.

Frequency response measurement system 1A is an example of the configuration in which frequency response measurement device 10 outputs the first excitation signal, the second excitation signal, and the third excitation signal once each, and measures the first frequency response, the second frequency response, and the third frequency response on the basis of each of the first identification input signal, the second identification input signal, and the third identification signal, and the first identification output signal, the second identification output signal, and the third identification signal each obtained once from servo system 20 to which the first excitation signal, the second excitation signal, and the third excitation signal each outputted once are inputted. In contrast, frequency response measurement system according to Variation 3 is an example of the configuration in which the frequency response measurement device according to Variation 3 outputs the first excitation signal, the second excitation signal, and the third excitation signal a plurality of times each, and measures the first frequency response, the second frequency response, and the third frequency response on the basis of each of the first identification input signal, the second identification input signal, and the third identification signal, and the first identification output signal, the second identification output signal, and the third identification signal each obtained a plurality of times from the servo system according to Variation 3 to which the first excitation signal, the second excitation signal, and the third excitation signal each outputted a plurality of times are inputted.

The following describes the frequency response measurement system according to Variation 3, focusing on the differences from frequency response measurement system 1A. In the following description, the same reference signs are assigned to the same elements as those of frequency response measurement system 1A and detailed description of the same elements, which have already been described, are omitted.

FIG. 16 is a block diagram showing the configuration of frequency response measurement system 1D according to Variation 3.

As shown in FIG. 16, frequency response measurement system 1D is configured by being changed from frequency response measurement system 1A according to Embodiment 2; frequency response measurement device 10A is replaced by frequency response measurement device 10D. Also, frequency response measurement device 10D is configured by being changed from frequency response measurement device 10A; first outputter 11 is replaced by first outputter 11D, first excitation signal generator 112 is replaced by first excitation signal generator 112D, second outputter 12 is replaced by second outputter 12D, second excitation signal generator 122 is replaced by second excitation signal generator 122D, third outputter 14 is replaced by third outputter 14D, and frequency response calculator 13 is replaced by frequency response calculator 13D.

First outputter 11D includes first measurement condition calculator 111 and first excitation signal generator 112D, and outputs the first excitation signal in the first frequency range a plurality of times.

On the basis of the amplitude of the first excitation signal calculated by first measurement condition calculator 111, first excitation signal generator 112D generates the first excitation signal having such amplitude and outputs, to excitation signal selector 16, the generated first excitation signal a plurality of times. The description here assumes that the first frequency range is the entire frequency range of the frequency response measured by frequency response measurement device 10D. The description here also assumes that the first excitation signal is a torque instruction (first torque instruction) for specifying the torque of motor 22.

The first excitation signal outputted by first excitation signal generator 112D is any one of a white noise signal, a multi-sine wave signal, a sine wave sweep signal, a step signal, or a ramp signal.

Second outputter 12D includes second measurement condition calculator 121 and second excitation signal generator 122D, and outputs the second excitation signal in the second frequency range that forms a part of the first frequency range a plurality of times.

On the basis of the amplitude of the second excitation signal calculated by second measurement condition calculator 121, second excitation signal generator 122D generates the second excitation signal having such amplitude and outputs, to excitation signal selector 16, the generated second excitation signal a plurality of times. The description here assumes that the second excitation signal is a torque instruction (second torque instruction) for specifying the torque of motor 22, as in the case of the first excitation signal.

The second excitation signal outputted by second excitation signal generator 122D is any one of a multi-sine wave signal or a sine wave sweep signal.

Third outputter 14D includes third measurement condition calculator 141 and third excitation signal generator 142D, and outputs the third excitation signal in the third frequency range a plurality of times.

On the basis of the amplitude of the third excitation signal calculated by third measurement condition calculator 141, third excitation signal generator 142D generates the third excitation signal having such amplitude and outputs, to excitation signal selector 16, the generated third excitation signal a plurality of times. The description here assumes that the third excitation signal is a torque instruction (third torque instruction) for specifying the torque of motor 22, as in the case of the first excitation signal and the second excitation signal.

The third excitation signal outputted by third excitation signal generator 142D is any one of a multi-sine wave signal or a sine wave sweep signal.

Frequency response calculator 13D calculates the frequency response of servo system 20 on the basis of dentification input signals inputted to servo system 20 to obtain the frequency responses of servo system 20 and identification output signals outputted from servo system 20 to obtain the frequency responses of servo system 20. In so doing, frequency response calculator 13D performs sampling to obtain the identification input signals and the identification output signals.

Here, each of the identification input signals may be, for example, an excitation signal itself outputted from frequency response measurement device 10D, or may be a control signal that is generated in motor control device 21 on the basis of the excitation signal outputted from frequency response measurement device 10D to drive motor 22. Here, the control signal that is generated in motor control device 21 on the basis of the excitation signal outputted from frequency response measurement device 10D to drive motor 22 may be, for example, a feedback torque instruction. The description here assumes that each of the identification input signals is the excitation signal inputted to servo system 20.

Also, each of the identification output signals may be, for example, a state signal outputted from first state quantity measurement device 24. The description here assumes that the identification output signal is the state signal outputted from first state quantity measurement device 24.

Stated differently, (1) when the first excitation signal in the first frequency range outputted from frequency response measurement device 10D is inputted to servo system 20 a plurality of times, frequency response calculator 13D calculates the first frequency response of servo system 20 in the first frequency range on the basis of the first excitation signal and the first state signal obtained a plurality of times in the first sampling cycle. (2) When the second excitation signal in the second frequency range outputted from frequency response measurement device 10D is inputted to servo system 20 a plurality of times, frequency response calculator 13D calculates the second frequency response of servo system 20 in the second frequency range on the basis of the second excitation signal and the second state signal that are obtained a plurality of times in the second sampling cycle that is longer than or equal to the first sampling cycle. (3) When the third excitation signal in the third frequency range outputted from frequency response measurement device 10D is inputted to servo system 20 a plurality of times, frequency response calculator 13D calculates the third frequency response of servo system 20 in the third frequency range on the basis of the third excitation signal and the third state signal that are obtained a plurality of times in the third sampling cycle that is longer than or equal to the first sampling cycle.

More specifically, (1) when the first excitation signal is inputted to servo system 20 a plurality of times, frequency response calculator 13D calculates the first frequency response of servo system 20 in the first frequency range on the basis of: the first input torque instruction outputted a plurality of times from motor control device 21 in servo system 20 to which the first excitation signal is inputted a plurality of times and obtained a plurality of times in the first sampling cycle; and the first state signal outputted a plurality of times from first state quantity measurement device 24 in servo system 20 to which the first excitation signal is inputted a plurality of times and obtained a plurality of times in the first sampling cycle. Also, (2) when the second excitation signal is inputted to servo system 20 a plurality of times, frequency response calculator 13D calculates the second frequency response of servo system 20 in the second frequency range on the basis of: the second input torque instruction outputted a plurality of times from motor control device 21 in servo system 20 to which the second excitation signal is inputted a plurality of times and obtained a plurality of times in the second sampling cycle that is longer than or equal to the first sampling cycle; and the second state signal outputted a plurality of times from first state quantity measurement device 24 in servo system 20 to which the second excitation signal is inputted a plurality of times and obtained a plurality of times in the second sampling cycle that is longer than or equal to the first sampling cycle. (3) When the third excitation signal is inputted to servo system 20 a plurality of times, frequency response calculator 13D calculates the third frequency response of servo system 20 in the third frequency range on the basis of: the third input torque instruction outputted a plurality of times from motor control device 21 in servo system 20 to which the third excitation signal is inputted a plurality of times and obtained a plurality of times in the third sampling cycle that is longer than or equal to the first sampling cycle; and the third state signal outputted a plurality of times from first state quantity measurement device 24 in servo system 20 to which the third excitation signal is inputted a plurality of times and obtained a plurality of times in the third sampling cycle that is longer than or equal to the first sampling cycle.

The description here assumes that the frequency responses calculated by frequency response calculator 13D are the frequency responses of the rotational speed [rpm] of motor 22 relative to the input torques [Nm] inputted to servo system 20.

<Consideration>

In general, when measuring the state quantity of servo system 20 from servo system 20, first state quantity measurement device 24 measures the state quantity of servo system 20, and also measures the influence of noise superimposed on the state quantity of servo system 20. For this reason, there is a fear that the state quantity of servo system 20 measured by first state quantity measurement device 24 varies for each measurement of the state quantity, due to the influence of the superimposed noise.

In contrast, according to frequency response measurement device 10D having the above configuration, the second frequency response is calculated on the basis of the first excitation signal obtained a plurality of times and the first state signal obtained a plurality of times, the second frequency response is calculated on the basis of the second excitation signal obtained a plurality of times and the second state signal obtained a plurality of times, and the second frequency response is calculated on the basis of the second excitation signal obtained a plurality of times and the second state signal obtained a plurality of times.

At this time, it is possible in frequency response arithmetic unit 18 to determine whether the accuracy of state signal measurement is good or poor by evaluating the average, the dispersion, or/and the coherence, etc. of a plurality of state signals. Further, it is possible, for example, to calculate the first frequency response, the second frequency response, and the third frequency response on the basis of the average of only the state signals whose measurement accuracy has been determined to be good. For this reason, according to frequency response measurement device 10D having the above configuration, it is possible to obtain a more accurate frequency response of servo system 20 with reduced noise influence in the measurement of the state quantity of servo system 20.

(Supplement)

Examples of the technique disclosed in the present application have been described above on the basis of Embodiment 1, Embodiment 2, and Variations 1 to 3. However, the present disclosure is not limited to these embodiments and variations. The scope of one or more aspects of the present disclosure may also include an embodiment achieved by making various modifications to the embodiments and the variations that can be conceived by those skilled in the art and an embodiment configured by freely combining elements in different embodiments or variations without departing from the essence of the present disclosure.

An aspect of the present disclosure may not only be such frequency response measurement system 1 and so forth, but also a frequency response measurement method that includes, as its steps, the characteristic elements included in frequency response measurement system 1 and so forth. An aspect of the present disclosure may also be a computer program for causing a computer to execute the characteristic steps included in the frequency response measurement method. An aspect of the present disclosure may also be a non-transitory, computer-readable recording medium having recorded thereon such a computer program.

[Industrial Applicability]

The present disclosure is widely applicable, for example, to systems for measuring frequency responses.

[Reference Signs List]

1, 1A, 1B, 1C, 1D frequency response measurement system
10, 10A, 10B, 10C, 10D frequency response measurement device
11, 11D first outputter
12, 12D second outputter
13, 13B, 13C, 13D frequency response calculator
14, 14D third outputter
15 frequency response outputter
16, 16A excitation signal selector
17, 17B, 17C Fourier transformer
18 frequency response arithmetic unit
19 frequency response synthesizer
20, 20B, 20C servo system
21 motor control device
22 motor
23 load
24 first state quantity measurement device
25 second state quantity measurement device
111 first measurement condition calculator
112, 112D first excitation signal generator
121 second measurement condition calculator
122, 122D second excitation signal generator
141 third measurement condition calculator
142, 142D third excitation signal generator

**Claims**

**1.** A frequency response measurement method of measuring a frequency response of a servo system, the frequency response measurement method comprising:

outputting, to the servo system, a first excitation signal in a first frequency range;
calculating a first frequency response of the servo system in the first frequency range based on a first identification input signal and a first identification output signal that are obtained in a first sampling cycle from the servo system to which the first excitation signal is inputted, the first identification input signal being a signal inputted to the servo system to obtain the frequency response of the servo system, the first identification output signal being a signal outputted from the servo system to obtain the frequency response of the servo system;
outputting, to the servo system, a second excitation signal in a second frequency range that forms a part of the first frequency range, the second excitation signal being a signal generated based on the first frequency response; and
calculating a second frequency response of the servo system in the second frequency range based on a second identification input signal and a second identification output signal that are obtained in a second sampling cycle that is longer than or equal to the first sampling cycle from the servo system to which the second excitation signal is inputted, the second identification input signal being a signal inputted to the servo system to obtain the frequency response of the servo system, the second identification output signal being a signal outputted from the servo system to obtain the frequency response of the servo system.

2. The frequency response measurement method according to claim 1,
wherein the second sampling cycle is longer than the first sampling cycle.

3. The frequency response measurement method according to claim 1,
wherein the first excitation signal is any one of a pseudo random signal, a multi-sine wave signal, a sine wave sweep signal, a step signal, or a ramp signal.

4. The frequency response measurement method according to claim 1,
wherein the second excitation signal is any one of a multi-sine wave signal or a sine wave sweep signal.

5. The frequency response measurement method according to claim 1, further comprising:

calculating an amplitude of the first excitation signal based on at least one of a total inertia or a friction response of the servo system,
wherein the outputting of the first excitation signal includes outputting, to the servo system, the first excitation signal having the amplitude of the first excitation signal calculated in the calculating of the amplitude of the first excitation signal.

6. The frequency response measurement method according to claim 1, further comprising:

calculating an amplitude of the second excitation signal based on the first frequency response,
wherein the outputting of the second excitation signal includes outputting, to the servo system, the second excitation signal having the amplitude of the second excitation signal calculated in the calculating of the amplitude of the second excitation signal.

7. The frequency response measurement method according to claim 1, further comprising:

outputting, to the servo system, a third excitation signal in a third frequency range, the third excitation signal being a signal generated based on the first frequency response, the third frequency range being a frequency range that forms a part of the first frequency range and defined by a first frequency that is higher than a lower limit frequency of the second frequency range and a second frequency that is higher than or equal to an upper limit frequency of the second frequency range; and
calculating a third frequency response of the servo system in the third frequency range based on a third identification input signal and a third identification output signal that are obtained in a third sampling cycle that is longer than or equal to the first sampling cycle from the servo system to which the third excitation signal is inputted, the third identification input signal being a signal inputted to the servo system to obtain the frequency response of the servo system, the third identification output signal being a signal outputted from the servo system to obtain the frequency response of the servo system.

8. The frequency response measurement method according to claim 7, further comprising:

synthesizing the second frequency response and the third frequency response to calculate a fourth frequency response of the servo system.

9. The frequency response measurement method according to claim 7,
wherein the third sampling cycle is longer than the first sampling cycle.

10. The frequency response measurement method according to claim 7,
wherein the second frequency range and the third frequency range are continuous.

11. The frequency response measurement method according to claim 7,
wherein the lower limit frequency in the third frequency range is within the second frequency range.

12. The frequency response measurement method according to claim 7,
wherein at least one of the second frequency range or the third frequency range includes at least one of a resonance frequency or an anti-resonance frequency of the servo system.

13. The frequency response measurement method according to claim 8, further comprising:
outputting, to a display device, at least one of the second frequency response, the third frequency response, or the fourth frequency response.

14. The frequency response measurement method according to claim 1, further comprising:

calculating an amplitude of the first excitation signal based on at least one of a total inertia or a friction response of the servo system, and control parameter setting of the servo system; and
calculating an amplitude of the second excitation signal based on the first frequency response and the control parameter setting,
wherein the outputting of the first excitation signal includes outputting, to the servo system, the first excitation signal having the amplitude of the first excitation signal calculated in the calculating of the amplitude of the first excitation signal, and
the outputting of the second excitation signal includes outputting, to the servo system, the second excitation signal having the amplitude of the second excitation signal calculated in the calculating of the amplitude of the second excitation signal.

15. The frequency response measurement method according to claim 1,
wherein the first identification output signal and the second identification output signal each include sensor information indicating a state quantity of a target to be driven in the servo system, the state quantity being obtained by sensing the target to be driven.

16. The frequency response measurement method according to claim 1,

wherein the outputting of the first excitation signal includes outputting the first excitation signal a plurality of times,
the outputting of the second excitation signal includes outputting the second excitation signal a plurality of times,
the calculating of the first frequency response includes calculating the first frequency response based on each of the first identification input signal and the first identification output signal that are obtained a plurality of times from the servo system to which the first excitation signal is inputted a plurality of times, and
the calculating of the second frequency response includes calculating the second frequency response based on each of the second identification input signal and the second identification output signal that are obtained a plurality of times from the servo system to which the second excitation signal is inputted a plurality of times.

17. The frequency response measurement method according to claim 1,
wherein the first identification input signal and the second identification input signal have an equal sampling number.

18. A frequency response measurement device that measures a frequency response of a servo system, the frequency response measurement device comprising:

a first outputter that outputs, to the servo system, a first excitation signal in a first frequency range;
a frequency response calculator that calculates a first frequency response of the servo system in the first frequency range based on a first identification input signal and a first identification output signal that are obtained in a first sampling cycle from the servo system to which the first excitation signal is inputted, the first identification input signal being a signal inputted to the servo system to obtain the frequency response of the servo system, the first identification output signal being a signal outputted from the servo system to obtain the frequency response of the servo system; and

a second outputter that outputs, to the servo system, a second excitation signal in a second frequency range that forms a part of the first frequency range, the second excitation signal being a signal generated based on the first frequency response,

wherein the frequency response calculator further calculates a second frequency response of the servo system in the second frequency range based on a second identification input signal and a second identification output signal that are obtained in a second sampling cycle that is longer than or equal to the first sampling cycle from the servo system to which the second excitation signal is inputted, the second identification input signal being a signal inputted to the servo system to obtain the frequency response of the servo system, the second identification output signal being a signal outputted from the servo system to obtain the frequency response of the servo system.

FIG. 1

EP 4 703 811 A1

FIG. 2A

Torque

Time

FIG. 2B

Torque

Time

FIG. 2C

Torque

Time

FIG. 2D

FIG. 2E

# FIG. 3

# FIG. 4

## FIG. 5

Gain [dB]

First frequency range

Second frequency range

x [dB]

Line: rigid-body approximated frequency response

Frequency [Hz]

## FIG. 6

Gain [dB]

First frequency range

Second frequency range

Frequency [Hz]

EP 4 703 811 A1

# FIG. 7

First frequency response measurement processing
Start

↓ S10

Output first excitation signal in first frequency range

↓ S20

Calculate first frequency response, based on first identification input signal and first identification output signal obtained in first sampling cycle

↓ S30

Output second excitation signal in second frequency range, based on first frequency response

↓ S40

Calculate second frequency response, based on second identification input signal and second identification output signal obtained in second sampling cycle

↓ S50

Output first frequency response, second frequency response, or both first frequency response and second frequency response

↓

End

32

# FIG. 8

(A1) Time

(A2) Frequency

(B1) Time

(B2) Frequency range

EP 4 703 811 A1

FIG. 9

## FIG. 10

## FIG. 11

# FIG. 12

```
Second frequency response measurement processing
                    Start
```

S110

Output first excitation signal in first frequency range

S120

Calculate first frequency response, based on first
identification input signal and first identification output
signal obtained in first sampling cycle

S130

Output second excitation signal in second frequency
range, based on first frequency response

S140

Calculate second frequency response, based on second
identification input signal and second identification output
signal obtained in second sampling cycle

S150

Output third excitation signal in third frequency range,
based on first frequency response

S160

Calculate third frequency response, based on third
identification input signal and third identification output
signal obtained in third sampling cycle

S170

Calculate and output fourth frequency response by
synthesizing second frequency response and third
frequency response

```
                    End
```

# FIG. 13

# FIG. 14

EP 4 703 811 A1

FIG. 15

EP 4 703 811 A1

## FIG. 16

**1D**

**10D** Frequency response measurement device

**11D** First outputter
- **111** First measurement condition calculator
- **112D** First excitation signal generator

**12D** Second outputter
- **121** Second measurement condition calculator
- **122D** Second excitation signal generator

**14D** Third outputter
- **141** Third measurement condition calculator
- **142D** Third excitation signal generator

**16A** Excitation signal selector

**20** Servo system
- **21** Motor control device
- **22** M
- **23** L
- **24**

**13D** Frequency response calculator
- **18** Frequency response arithmetic unit
- **17** Fourier transformer
- **19** Frequency response synthesizer

EP 4 703 811 A1

40

## INTERNATIONAL SEARCH REPORT

| International application No. |
| --- |
| **PCT/JP2024/015610** |

### A. CLASSIFICATION OF SUBJECT MATTER

*G05B 11/36*(2006.01)i
FI: G05B11/36 501C

According to International Patent Classification (IPC) or to both national classification and IPC

### B. FIELDS SEARCHED

Minimum documentation searched (classification system followed by classification symbols)

G05B11/36

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | WO 2021/181787 A1 (OMRON CORPORATION) 16 September 2021 (2021-09-16)<br>entire text, all drawings | 1-18 |
| A | JP 2004-088937 A (FUJI ELECTRIC FA COMPONENTS & SYSTEMS CO., LTD.) 18 March 2004 (2004-03-18)<br>entire text, all drawings | 1-18 |
| A | JP 2011-186125 A (RICOH COMPANY, LTD.) 22 September 2011 (2011-09-22)<br>entire text, all drawings | 1-18 |

☐ Further documents are listed in the continuation of Box C.      ☑ See patent family annex.

| | | |
| --- | --- | --- |
| * | Special categories of cited documents: | |
| "A" | document defining the general state of the art which is not considered to be of particular relevance | "T" | later document published after the international filing date or priority date and not in conflict with the application but cited to understand the principle or theory underlying the invention |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" | document member of the same patent family |

| Date of the actual completion of the international search | Date of mailing of the international search report |
| --- | --- |
| **26 June 2024** | **09 July 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/015610**

| Patent document cited in search report | | | Publication date (day/month/year) | Patent family member(s) | | | Publication date (day/month/year) |
|---|---|---|---|---|---|---|---|
| WO | 2021/181787 | A1 | 16 September 2021 | US 2023/0084056 A1 entire text, all drawings CN 115151802 A | | | |
| JP | 2004-088937 | A | 18 March 2004 | (Family: none) | | | |
| JP | 2011-186125 | A | 22 September 2011 | (Family: none) | | | |

Form PCT/ISA/210 (patent family annex) (July 2022)

**REFERENCES CITED IN THE DESCRIPTION**

**Patent documents cited in the description**

- JP 2019091141 A